# EUROPÄISCHE PATENTSCHRIFT

(11) **EP 3 556 179 B1**
(45) Veröffentlichungstag und Bekanntmachung des Hinweises auf die Patenterteilung: **26.03.2025**
(21) Anmeldenummer: 17822458.0
(22) Anmeldetag: 11.12.2017
(51) Int. Cl.: H05B 6/06

(54) **HAUSHALTSGERÄTEVORRICHTUNG**
DOMESTIC APPLIANCE
DISPOSITIF POUR APPAREIL MÉNAGER

(30) Priorität: 19.12.2016 ES 201631616
(43) Veröffentlichungstag der Anmeldung: 23.10.2019
(73) Patentinhaber: BSH Hausgeräte GmbH, 81739 München (DE)
(72) Erfinder: CABEZA GOZALO, Tomas, 50010 Zaragoza (ES); LLORENTE GIL, Sergio, 50009 Zaragoza (ES); MILLAN SERRANO, Ignacio, 50018 Zaragoza (ES)
(86) Internationale Anmeldenummer: PCT/IB2017/057772
(87) Internationale Veröffentlichungsnummer: WO 2018/116050

(56) Entgegenhaltungen:
- EP-A1- 0 862 714
- EP-A1- 1 303 168
- EP-A1- 1 734 789
- EP-A1- 2 506 666
- EP-A1- 2 586 271

## Beschreibung

Die Erfindung betrifft eine Haushaltsgerätevorrichtung, insbesondere eine Gargerätevorrichtung, nach dem Oberbegriff des Anspruchs 1 und ein Verfahren zum Betrieb einer Haushaltsgerätevorrichtung nach dem Oberbegriff des Anspruchs 8.

Aus dem Stand der Technik ist bereits eine Haushaltsgerätevorrichtung mit zumindest einer Wechselrichtereinheit in Halbbrücken- oder Vollbrückenschaltung zum Betrieb mehrerer Induktoren mittels eines Multiplexers bekannt.

Die EP 2 586 271 A1 offenbart eine Haushaltsgerätevorrichtung nach dem Oberbegriff des Anspruchs 1.

Die Aufgabe der Erfindung besteht insbesondere darin, eine gattungsgemäße Vorrichtung mit verbesserten Eigenschaften hinsichtlich einer Effizienz, insbesondere einer Kosteneffizienz und/oder einer Energieeffizienz, bereitzustellen. Die Aufgabe wird erfindungsgemäß durch die Merkmale der Patentansprüche 1 und 8 gelöst, während vorteilhafte Ausgestaltungen und Weiterbildungen der Erfindung den Unteransprüchen entnommen werden können.

Die Erfindung geht aus von einer Haushaltsgerätevorrichtung, insbesondere einer Gargerätevorrichtung, vorzugsweise einer Kochfeldvorrichtung, mit zumindest einem Induktor, insbesondere mit zumindest zwei und vorzugsweise mehreren Induktoren, mit zumindest einer Schalteinheit, an welcher in zumindest einem Betriebszustand zumindest eine insbesondere periodische Betriebsspannung anliegt, und mit einer Steuereinheit, welche dazu vorgesehen ist, durch Schalten der Schalteinheit zumindest eine Versorgungsspannung für den Induktor bereitzustellen, wobei die Steuereinheit dazu vorgesehen ist, in zumindest einem Betriebszustand zumindest eine Frequenz einer Puls-Modulation der Versorgungsspannung innerhalb zumindest einer Periode der Betriebsspannung zu variieren.

Die Steuereinheit ist dazu vorgesehen, in dem Betriebszustand zusätzlich zumindest einen Tastgrad de Puls-Modulation der Versorgungsspannung innerhalb der zumindest einen Periode der Betriebsspannung zu variieren.

Unter einer "Haushaltsgerätevorrichtung" soll in diesem Zusammenhang insbesondere zumindest ein Teil, vorzugsweise zumindest eine Unterbaugruppe, eines Haushaltsgeräts, verstanden werden. Insbesondere kann die Haushaltsgerätevorrichtung auch das gesamte Haushaltsgerät umfassen. Das Haushaltsgerät ist insbesondere als ein Gargerät, vorzugsweise als eine Mikrowelle, ein Backofen und/oder ein, insbesondere variables, Kochfeld, insbesondere ein Matrixkochfeld, und besonders bevorzugt als ein induktives Gargerät, wie insbesondere ein Induktionsbackofen und/oder vorzugsweise ein Induktionskochfeld, ausgebildet. Unter einer "Gargerätevorrichtung" soll insbesondere eine Haushaltsgerätevorrichtung verstanden werden, welche zumindest teilweise ein Gargerät ausbildet. Unter einem "variablen Kochfeld" soll in diesem Zusammenhang insbesondere ein Kochfeld verstanden werden, bei welchem Induktoren, insbesondere in einer regelmäßigen räumlichen Anordnung, insbesondere unter einer Kochfeldplatte, angeordnet sind und zumindest teilweise wenigstens eine variable Heizzone, vorzugsweise mehrere variable Heizzonen ausbilden, die einen Bereich der Kochfeldplatte vorzugsweise von wenigstens 10%, vorzugsweise von zumindest 30% und besonders vorteilhaft von zumindest 40% einer Gesamtfläche der Kochfeldplatte umfasst/umfassen. Insbesondere sind die Induktoren dazu vorgesehen, abhängig von einer Position eines auf der Kochfeldplatte positionierten Gargeschirrs die Heizzone auszubilden und an das Gargeschirr anzupassen. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Unter einem "Induktor" soll insbesondere ein elektrisches Bauteil verstanden werden, welches in zumindest einem Garbetriebszustand dazu vorgesehen ist, zumindest teilweise wenigstens ein Gargeschirr, welches auf der Kochfeldplatte positioniert ist, induktiv zu erwärmen. Der Induktor umfasst zumindest einen, vorzugsweise in Form einer Kreisscheibe, gewickelten elektrischen Leiter, der in zumindest dem Garbetriebszustand von einem hochfrequenten Heizstrom durchflossen wird. Der Induktor ist vorzugsweise dazu vorgesehen, elektrische Energie in ein magnetisches Wechselfeld umzuwandeln, um in dem Gargeschirr Wirbelströme und/oder Ummagnetisierungseffekte hervorzurufen, die in Wärme umgewandelt werden. Unter einem "Schaltelement" soll in diesem Zusammenhang insbesondere ein Element verstanden werden, welches dazu vorgesehen ist, in zumindest einem ersten Schaltzustand einen ersten Anschluss mit zumindest einem zweiten Anschluss elektrisch leitend zu verbinden und in zumindest einem zweiten Schaltzustand den ersten Anschluss von dem zweiten Anschluss zumindest zu trennen. Das Schaltelement weist insbesondere zumindest einen Steueranschluss auf, über welchen der Schaltzustand des Schaltelements steuerbar ist. Das Schaltelement ist dazu vorgesehen, in einem Schaltvorgang von einem der Schaltzustände in den jeweils anderen Schaltzustand überzugehen. Das Schaltelement kann dabei als ein beliebiges, einem Fachmann als sinnvoll erscheinendes Schaltelement, vorzugsweise Halbleiterschaltelement, ausgebildet sein, wie beispielsweise als Transistor, vorzugsweise als FET, als MOSFET und/oder als IGBT, vorzugsweise als RC-IGBT und besonders bevorzugt als ein HEMT-Transistor. Unter einem "HEMT-Transistor" soll insbesondere ein High-Electron-Mobility-Transistor, insbesondere mit einer besonders hohen Elektronen-Mobilität, verstanden werden, welche insbesondere bei 25°C, insbesondere zumindest 400 cm² V⁻¹s⁻¹, bevorzugt zumindest 600 cm² V⁻¹s⁻¹, weiter bevorzugt zumindest 800 cm² V⁻¹s⁻¹ und besonders bevorzugt zumindest 1000 cm² V⁻¹s⁻¹ beträgt. Ferner sollen insbesondere Modulation-Doped Field-Effect-Transistoren (MODFET), Two-Dimensional Electron-Gas-Field-Effect-Transistoren (TEGFET), Selectively-Doped Heterojunction-Transistoren (SDHT) und/oder Heterojunction-Field-Effect-Transistoren (HFET) als HEMT-Transistoren verstanden werden. Insbesondere weist das Schaltelement zumindest einen ersten Anschluss, welcher vorzugsweise ein Source-Anschluss ist, einen zweiten Anschluss, welcher vorzugsweise ein Drain-Anschluss ist, und/oder einen Steueranschluss, welcher insbesondere ein Gate-Anschluss ist, auf. Dem Schaltelement können insbesondere zumindest eine Diode, insbesondere eine Rückspeisediode, und/oder zumindest eine Kapazität, insbesondere eine Dämpfungskapazität, der Haushaltsgerätevorrichtung parallel geschaltet sein. Unter einer "Schalteinheit" soll in diesem Zusammenhang insbesondere eine Einheit verstanden werden, welche zumindest ein Schaltelement aufweist. Unter einer "Betriebsspannung" soll in diesem Zusammenhang insbesondere eine Spannung verstanden werden, welche zu einer Übertragung von Leistung innerhalb der Haushaltsgerätevorrichtung vorgesehen ist. Die Betriebsspannung weist insbesondere eine Frequenz von zumindest 100 Hz und/oder von zumindest 120 Hz auf. Die Betriebsspannung ist insbesondere eine gleichgerichtete Netzspannung und weist vorzugsweise eine Frequenz auf, welche einer doppelten Netzfrequenz der Netzspannung entspricht. Unter einer "Netzspannung" soll in diesem Zusammenhang insbesondere eine von einem Energieversorger in einem Stromnetz bereitgestellte elektrische Spannung, insbesondere Wechselspannung, verstanden werden, welche zur Übertragung elektrischer Leistung eingesetzt wird. Die Netzspannung weist insbesondere zumindest eine Netzfrequenz von zumindest 50 Hz und/oder 60 Hz auf und ist insbesondere zumindest mittels eines Gleichrichters der Haushaltsgerätevorrichtung, vorzugsweise eines Brückengleichrichters, gleichgerichtet und zumindest teilweise in die Betriebsspannung gewandelt. Unter einer "Steuereinheit" soll insbesondere eine elektronische Einheit verstanden werden, die vorzugsweise in einer Steuer- und/oder Regeleinheit eines Haushaltsgeräts zumindest teilweise integriert ist. Vorzugsweise umfasst die Steuereinheit eine Recheneinheit und insbesondere zusätzlich zur Recheneinheit eine Speichereinheit mit einem darin gespeicherten Steuer- und/oder Regelprogramm, das dazu vorgesehen ist, von der Recheneinheit ausgeführt zu werden. Unter einem "Schalten der Schalteinheit" soll in diesem Zusammenhang insbesondere ein Schaltvorgang zumindest eines Schaltelements der Schalteinheit verstanden werden, in dem das Schaltelement von einem der Schaltzustände in einen anderen Schaltzustand übergeht. Unter einer "Versorgungsspannung" soll in diesem Zusammenhang insbesondere eine Spannung verstanden werden, welche zum Betrieb zumindest eines Induktors vorgesehen ist. Die Versorgungsspannung weist insbesondere eine Frequenz auf, welche größer als eine Frequenz der Betriebsspannung ist. Insbesondere beträgt eine Frequenz der Versorgungsspannung zumindest 1 kHz, vorzugsweise zumindest 10 kHz und besonders bevorzugt zumindest 50 kHz und/oder insbesondere höchstens 200 kHz, vorzugsweise höchstens 150 kHz und besonders bevorzugt höchstens 100 kHz. Die Versorgungsspannung ist insbesondere eine Pulsspannung. Ein Zeitabstand zwischen zwei Pulsen entspricht der inversen Frequenz der Versorgungsspannung. Insbesondere entspricht jeder Puls zumindest einem Schaltvorgang der Schalteinheit. Die Steuereinheit ist insbesondere dazu vorgesehen, vorzugsweise mittels der Schalteinheit, durch zumindest eine Puls-Modulation, insbesondere zumindest eine Puls-Amplituden-Modulation, die Betriebsspannung zumindest teilweise in eine weitere Spannung, vorzugsweise die Versorgungsspannung, zu wandeln. Darunter, dass "zumindest eine Frequenz der Versorgungsspannung innerhalb zumindest einer Periode der Betriebsspannung variiert wird", soll insbesondere verstanden werden, dass die Versorgungsspannung innerhalb einer Periode der Betriebsspannung zumindest zwei verschiedene Frequenzen aufweist. Ferner ist die Steuereinheit dazu vorgesehen, in dem Betriebszustand zusätzlich zumindest einen Tastgrad der Versorgungsspannung zu variieren, wobei vorzugsweise eine Pulsdauer konstant bleibt. Darunter, dass "zumindest ein Tastgrad der Versorgungsspannung innerhalb zumindest einer Periode der Betriebsspannung variiert wird", soll insbesondere verstanden werden, dass die Versorgungsspannung innerhalb einer Periode der Betriebsspannung zumindest zwei verschiedene Tastgrade aufweist. Insbesondere ist eine Variation des Tastgrads bei konstanter Pulsdauer direkt proportional zur Variation der Frequenz. Die Steuereinheit ist dazu vorgesehen, insbesondere mittels der Schalteinheit, die Frequenz und insbesondere den Tastgrad der Versorgungsspannung durch eine Puls-Modulation, insbesondere eine Puls-Weiten-Modulation und/oder eine Puls-Pausen-Modulation, insbesondere der Betriebsspannung und/oder einer Wechselrichterspannung, zu variieren.

Durch die erfindungsgemäße Ausgestaltung kann insbesondere eine Haushaltsgerätevorrichtung mit verbesserten Eigenschaften hinsichtlich einer Effizienz, insbesondere einer Kosteneffizienz und/oder einer Energieeffizienz bereitgestellt werden. Vorteilhaft kann ein variabler Betrieb von Induktoren verbessert werden. Weiter vorteilhaft kann eine Ansteuerung der Induktoren schneller erfolgen.

Es wird ferner vorgeschlagen, dass die Steuereinheit dazu vorgesehen ist, beim Variieren der Frequenz eine Überlast an zumindest einem elektrischen Bauteil, insbesondere an dem Induktor und/oder insbesondere an elektrischen Bauteilen, welche zusammen mit dem Induktor einen Schwingkreis ausbilden, wie beispielsweise einer Kapazität der Haushaltsgerätevorrichtung, zu vermeiden. Unter einer "Überlast" soll in diesem Zusammenhang insbesondere eine Überspannung, welche an zumindest einem elektrischen Bauteil anliegt, und/oder ein Überstrom, welcher durch zumindest ein elektrisches Bauteil fließt, verstanden werden und welche/welcher insbesondere zu einer Beschädigung, wie beispielsweise einem Kurzschluss, des elektrischen Bauteils führen kann. Insbesondere ist die Steuereinheit dazu vorgesehen, die Frequenz der Versorgungsspannung in zumindest einem Teilbereich der Betriebsspannung zu variieren, in welchem in einem Betriebszustand, welcher frei von einer solchen Variation der Frequenz ist, eine Überlast an dem zumindest einen elektrischen Bauteil anliegt. Die Steuereinheit ist insbesondere dazu vorgesehen, eine in einer Recheneinheit hinterlegte Leistungskennlinie bei einer Ansteuerung zu berücksichtigen, wobei die Leistungskennlinie insbesondere abhängig ist von einem Überdeckungsgrad des Induktors und/oder einem Material eines Gargeschirrs, welches über dem Induktor angeordnet ist. Hierdurch kann eine Beschädigung von elektrischen Bauteilen durch eine Überlast vermieden werden. Insbesondere können Bauteilkosten reduziert werden, da diese nicht mehr ausgelegt werden müssen, Leistungsspitzen abzufangen. Weiterhin kann vorteilhaft eine Standzeit der Haushaltsgerätevorrichtung erhöht werden.

Ferner wird vorgeschlagen, dass die Steuereinheit dazu vorgesehen ist, beim Variieren der Frequenz eine elektromagnetische Abstrahlung zu vermindern. Hierdurch kann vorteilhaft eine elektromagnetische Verträglichkeit verbessert werden. Insbesondere kann die elektromagnetische Verträglichkeit unabhängig von einer für einen Garvorgang benötigten Leistung angepasst werden. Weiter vorteilhaft kann auf zusätzliche Bauteile zur Verringerung elektromagnetischer Abstrahlung, wie beispielsweise eine zusätzliche Abschirmung, verzichtet werden.

In einer bevorzugten Ausgestaltung der Erfindung wird vorgeschlagen, dass die Haushaltsgerätevorrichtung zumindest einen weiteren Induktor umfasst, wobei die Steuereinheit dazu vorgesehen ist, durch Schalten der Schalteinheit zumindest eine weitere Versorgungsspannung für den weiteren Induktor bereitzustellen und in zumindest einem Betriebszustand zumindest eine weitere Frequenz der weiteren Versorgungsspannung innerhalb zumindest einer Periode der Betriebsspannung zu variieren. Hierdurch kann eine Flexibilität gesteigert werden.

Um eine Ansteuerung der Induktoren weiter zu verbessern, wird vorgeschlagen, dass die Versorgungsspannung und die weitere Versorgungsspannung zumindest teilweise, insbesondere zumindest zu einem Großteil und besonders bevorzugt vollständig, zueinander komplementär ausgestaltet sind. Darunter, dass "die Versorgungsspannung und die weitere Versorgungsspannung zumindest teilweise zueinander komplementär ausgestaltet sind", soll in diesem Zusammenhang insbesondere verstanden werden, dass zumindest ein zeitlicher Verlauf des Versorgungsspannung und der weiteren Versorgungsspannung innerhalb zumindest einer Periode, vorzugsweise über einen Großteil der Periode und besonders bevorzugt über die gesamte Periode, der Betriebsspannung zueinander komplementär sind. Insbesondere weist die Versorgungsspannung zu einem Zeitpunkt ein lokales Maximum, insbesondere einen Spannungspuls auf, an welchem die weitere Versorgungsspannung ein lokales Minimum, insbesondere keinen Spannungspuls, aufweist.

In einer Ausgestaltung der Erfindung wird vorgeschlagen, dass die Schalteinheit zumindest eine Wechselrichtereinheit, die dazu vorgesehen ist, aus der Betriebsspannung zumindest eine Wechselrichterspannung zu erzeugen, und zumindest eine Variationsschalteinheit aufweist, die dazu vorgesehen ist, aus der Wechselrichterspannung zumindest die Versorgungsspannung und vorzugsweise auch die weitere Versorgungsspannung zu erzeugen. Unter einer "Wechselrichtereinheit" soll insbesondere eine Einheit verstanden werden, die dazu vorgesehen ist, einen hochfrequenten Heizstrom, vorzugsweise mit einer Frequenz von zumindest 1 kHz, insbesondere von wenigstens 10 kHz und vorteilhaft von mindestens 20 kHz, insbesondere zu einem Betrieb des Induktors, bereitzustellen und/oder zu erzeugen. Unter einer "Variationsschalteinheit" soll insbesondere eine Einheit verstanden werden, welche dazu vorgesehen ist, den Induktor und den weiteren Induktor abwechselnd mit der Versorgungsspannung zu beaufschlagen. Die Variationsschalteinheit weist zumindest ein zusätzliches Schaltelement auf, welches in zumindest einem Schaltzustand mit zumindest einem Induktor verbunden ist. Ferner kann das Schaltelement abhängig von einem Schaltzustand mit mehreren Induktoren verbunden sein. Insbesondere kann die Variationsschalteinheit mehrere Schaltelemente umfassen. Vorzugsweise ist das Schaltelement in einem ersten Schaltzustand mit dem Induktor und in einem zweiten Schaltzustand mit dem weiteren Induktor verbunden. Hierdurch können eine Wandlung der Versorgungsspannung und eine Variation der Versorgungsspannung separat erfolgen.

In einer besonders bevorzugten Ausgestaltung der Erfindung wird vorgeschlagen, dass die Steuereinheit dazu vorgesehen ist, die Versorgungsspannung in dem Betriebszustand mittels der Variationsschalteinheit zu variieren. Insbesondere ist die Steuereinheit dazu vorgesehen, mittels des Variationsschalters durch eine Puls-Pausen-Modulation die Wechselrichterspannung zumindest teilweise in die Versorgungsspannung und vorzugsweise in die weitere Versorgungsspannung zu wandeln. Hierdurch kann vorteilhaft auf besonders einfache Art und Weise eine komplementäre Variation der Frequenz erreicht werden.

In einer weiteren Ausgestaltung der Erfindung wird vorgeschlagen, dass die Haushaltsgerätevorrichtung zumindest eine Heizmatrix umfasst, welche eine Anzahl N×M von Heizmatrixelementen aufweist, wobei die Schalteinheit zumindest eine Anzahl N von Zeilenschaltelementen und zumindest eine Anzahl M von Spaltenschaltelementen aufweist, wobei für beliebige i von 1 bis N und beliebige j von 1 bis M mit einer Gesamtanzahl N+M von Zeilenschaltelementen und Spaltenschaltelementen größer als 2 gilt, dass das i,j-te Heizmatrixelement zumindest einen i,j-ten Induktor umfasst und sowohl mit dem i-ten Zeilenschaltelement als auch mit dem j-ten Spaltenschaltelement verbunden ist. Unter einer "Anzahl" soll insbesondere in diesem Zusammenhang eine beliebige Zahl aus der Menge der natürlichen Zahlen verstanden werden. Insbesondere soll stets gelten, dass die Gesamtanzahl N+M von Spaltenschaltelementen und Zeilenschaltelementen größer als 2 ist, wenn die Anzahl N an Zeilenschaltelementen und/oder die Anzahl M an Spaltenschaltelementen größer als 1 ist. Unter einem "Zeilenschaltelement" und/oder einem "Spaltenschaltelement" sollen in diesem Zusammenhang insbesondere Schaltelemente verstanden werden, welche Zeilen und/oder Spalten eines Rasters einer schaltbildlichen Anordnung zugeordnet sind und/oder diese definieren. Die schaltbildliche Anordnung ist insbesondere verschieden von einer räumlichen Anordnung, in welcher die Spaltenschaltelemente und Zeilenschaltelemente in einer, von einem Fachmann bevorzugten und insbesondere besonders kompakten Anordnung angeordnet sein können. Die Zeilenschaltelemente sind insbesondere mit einem den Zeilenschaltelementen gemeinsamen Referenzpotential verbunden. Das den Zeilenschaltelementen gemeinsame Referenzpotential ist insbesondere ein Betriebspotential einer Betriebsspannung, mit welcher die Haushaltsgerätevorrichtung betrieben ist. Das den Zeilenschaltelementen gemeinsame Referenzpotential ist dabei insbesondere ein Massepotential. Die Spaltenschaltelemente sind insbesondere mit einem den Spaltenschaltelementen gemeinsamen weiteren Referenzpotential verbunden. Das den Spaltenschaltelementen gemeinsame weitere Referenzpotential ist insbesondere ein weiteres Betriebspotential der Betriebsspannung. Das den Spaltenschaltelementen gemeinsame weitere Referenzpotential ist insbesondere von einem Massepotential verschieden. Insbesondere liegt zwischen dem den Zeilenschaltelementen gemeinsamen Referenzpotential und dem den Spaltenschaltelementen gemeinsamen weiteren Referenzpotential eine Betriebsspannung an. Zumindest ein i-tes Zeilenschaltelement und zumindest ein j-tes Spaltenschaltelement, die insbesondere in einer Vollbrückentopologie oder vorzugsweise in einer Halbbrücken-Topologie verschaltet sind, dienen insbesondere als Wechselrichterschaltelemente und bilden gemeinsam zumindest teilweise, vorzugsweise vollständig, eine i,j-te Wechselrichtereinheit der Haushaltsgerätevorrichtung aus. Die Haushaltsgerätevorrichtung umfasst insbesondere eine Anzahl N×M von Wechselrichtereinheiten. Unter einer "i,j-ten Wechselrichtereinheit" soll insbesondere eine Einheit verstanden werden, die dazu vorgesehen ist, einen hochfrequenten Heizstrom, vorzugsweise mit einer Frequenz von zumindest 1 kHz, insbesondere von wenigstens 10 kHz und vorteilhaft von mindestens 20 kHz, insbesondere zu einem Betrieb des i,j-ten Induktors, bereitzustellen und/oder zu erzeugen. Die Steuereinheit der Haushaltsgerätevorrichtung ist insbesondere zu einer Ansteuerung der Zeilenschaltelemente und der Spaltenschaltelemente vorgesehen ist. Besonders vorteilhaft ist die Steuereinheit dazu vorgesehen, die Zeilenschaltelemente und die Spaltenschaltelemente als Wechselrichterschaltelemente anzusteuern, und zwar insbesondere derart, dass ein weicher Schaltvorgang zwischen zumindest einem ersten Schaltzustand und einem zweiten Schaltzustand der Schaltelemente auftritt. Unter einem "weichen Schaltvorgang" soll insbesondere ein Schaltvorgang mit einer verschwindend geringen Verlustleistung verstanden werden, welcher insbesondere dann auftritt, wenn der Schaltvorgang insbesondere zumindest im Wesentlichen stromfrei und/oder vorzugsweise zumindest im Wesentlichen spannungsfrei ist. Unter einem "zumindest im Wesentlichen stromfreien Schaltvorgang", welcher insbesondere auch unter der englischen Bezeichnung "zero current switching (ZCS)" bekannt ist, soll insbesondere ein weicher Schaltvorgang verstanden werden, bei dem ein Strom, der insbesondere unmittelbar vor einem Schaltvorgang in dem i,j-ten Heizmatrixelement und insbesondere in dem i,j-ten Induktor fließt, zumindest im Wesentlichen verschwindend gering, insbesondere im Wesentlichen nul, ist. Insbesondere ist die Steuereinheit dazu vorgesehen, die Schaltelemente bei einem zumindest im Wesentlichen stromfreien Schaltvorgang mit einer Schaltfrequenz zu schalten, welche kleiner oder gleich einer Resonanzfrequenz des i,j-ten Heizmatrixelements ist. Unter einem "zumindest im Wesentlichen spannungsfreien Schaltvorgang", welcher auch unter der englischen Bezeichnung "zero voltage switching (ZVS)" bekannt ist, soll insbesondere ein weicher Schaltvorgang verstanden werden, bei dem eine Spannung, die insbesondere unmittelbar vor einem Schaltvorgang an dem i,j-ten Heizmatrixelement und insbesondere an dem i,j-ten Induktor anliegt und/oder abfällt, zumindest im Wesentlichen verschwindend gering, insbesondere im Wesentlichen null, ist. Insbesondere ist die Steuereinheit dazu vorgesehen, die Schaltelemente bei einem zumindest im Wesentlichen spannungsfreien Schaltvorgang mit einer Schaltfrequenz zu schalten, welche größer ist als eine Resonanzfrequenz des i,j-ten Heizmatrixelements. Unter einem "verschwindend geringen Wert" soll insbesondere ein Wert verstanden werden, der insbesondere zumindest um einen Faktor 10, vorzugsweise zumindest um einen Faktor 50, bevorzugt zumindest um einen Faktor 100 und besonders bevorzugt zumindest um einen Faktor 500 geringer ist als ein Betriebsmaximalwert. Unter einer "Heizmatrix" soll insbesondere ein Raster einer schaltbildlichen Anordnung von i,j-ten Heizmatrixelementen verstanden werden. Das i,j-te Heizmatrixelement ist insbesondere zumindest mittelbar und vorzugsweise unmittelbar sowohl mit dem i-ten Zeilenschaltelement und dem j-ten Spaltenschaltelement verbunden. Darunter, dass "zumindest zwei elektrische Bauteile unmittelbar miteinander verbunden sind", soll in diesem Zusammenhang insbesondere verstanden werden, dass eine Verbindung zwischen den elektrischen Bauteilen frei von zumindest einem weiteren elektrischen Bauteil ist, welches eine Phase zwischen einem Strom und einer Spannung und/oder vorzugsweise einen Strom und/oder eine Spannung selbst verändert. Besonders bevorzugt weist der i,j-te Induktor zumindest einen, insbesondere genau einen i,j-ten Anschluss auf, welcher sowohl mit dem i-ten Zeilenschaltelement, insbesondere mit einem ersten Anschluss des i-ten Zeilenschaltelements, als auch mit dem j-ten Spaltenschaltelement, insbesondere mit einem zweiten Anschluss des j-ten Spaltenschaltelements, verbunden ist. Unter einem "Induktor" soll insbesondere ein elektrisches Bauteil verstanden werden, welches in zumindest einem Garbetriebszustand dazu vorgesehen ist, zumindest teilweise wenigstens ein Gargeschirr, welches auf der Kochfeldplatte der Haushaltsgerätevorrichtung positioniert ist, induktiv zu erwärmen. Der Induktor umfasst zumindest einen, vorzugsweise in Form einer Kreisscheibe, gewickelten elektrischen Leiter, der in zumindest dem Garbetriebszustand von einem hochfrequenten Heizstrom durchflossen wird. Der Induktor ist vorzugsweise dazu vorgesehen, elektrische Energie in ein magnetisches Wechselfeld umzuwandeln, um in dem Gargeschirr Wirbelströme und/oder Ummagnetisierungseffekte hervorzurufen, die in Wärme umgewandelt werden. Hierdurch kann eine Anzahl an Schaltelementen reduziert werden, da Schaltelemente teilweise mehrere Induktoren betreiben, wodurch Bauteilkosten eingespart werden können. Weiter vorteilhaft können verschiedene Induktoren der Heizmatrix individuell angesteuert werden, wodurch ein Energieverbrauch gesenkt und insbesondere ein elektrisches Streufeld reduziert werden kann. Besonders vorteilhaft ermöglicht die oben genannte Anordnung, dass die Schaltelemente weich geschaltet werden können, und zwar insbesondere zumindest im Wesentlichen stromfreien oder zumindest im Wesentlichen spannungsfrei, wodurch Schaltverluste reduziert werden können. Ferner kann eine vorteilhafte Detektion von Gargeschirren ermöglicht werden, wobei zusätzliche Bauteile, wie beispielsweise Sensorelemente, vermieden werden können.

Um einen für die Induktoren benötigten Bauraum zu verringern und insbesondere um eine effiziente räumliche Anordnung der Induktoren für einen Garbetrieb von Gargeschirren zu erreichen, wird ferner vorgeschlagen, dass die Induktoren räumlich in einer Induktormatrix angeordnet sind, welche bezüglich eines Nachbarschaftsverhältnisses von zumindest zwei der Induktoren relativ zueinander verschieden ist von der Heizmatrix, in welcher die Induktoren schaltbildlich angeordnet sind. Unter einer "Induktormatrix" soll insbesondere ein Raster einer räumlichen Anordnung der Induktoren unterhalb einer Kochfeldplatte der Haushaltsgerätevorrichtung verstanden werden. Unter einem " verschiedenen Nachbarschaftsverhältnis" soll insbesondere verstanden werden, dass nächste Nachbarn von i,j-ten Induktoren in der Induktormatrix nicht nächste Nachbarn von i,j-ten Induktoren in der Heizmatrix sind.

In einer bevorzugten Ausgestaltung der Erfindung wird vorgeschlagen, dass in der Induktormatrix die Induktoren räumlich so angeordnet sind, dass zumindest ein i,j-ter Induktor, für welchen i=j in der Heizmatrix gilt, zu zumindest einem i,j-ten Induktor benachbart ist, für welchen i≠j in der Heizmatrix gilt. Unter einem "i,j-ten Induktor, für welchen i=j in der Heizmatrix gilt" soll insbesondere ein Diagonalinduktor verstanden werden, welcher auf einer Diagonalen der Heizmatrix angeordnet ist. Unter einem "i,j-ten Induktor, für welchen i≠j in der Heizmatrix gilt" soll insbesondere ein Außerdiagonalinduktor verstanden werden, welcher außerhalb einer Diagonalen der Heizmatrix angeordnet ist. Vorzugsweise ist zwischen zumindest zwei i,j-ten Induktoren, für welche i=j in der Heizmatrix gilt, zumindest ein i,j-ter Induktor angeordnet, für welchen i≠j in der Heizmatrix gilt. Besonders bevorzugt ist ein i,j-ter Induktor für welchen i=j in der Heizmatrix gilt, von mehreren, insbesondere von zumindest drei, vorzugsweise von zumindest vier und besonders bevorzugt von zumindest fünf i,j-ten Induktoren, für welche i≠j in der Heizmatrix gilt, umgeben, vorzugsweise ringförmig umgeben. Alternativ ist denkbar, dass die Heizmatrix frei ist von i,j-ten Heizmatrixelementen und insbesondere i,j-ten Induktoren, für welche i=j in der Heizmatrix gilt. Hierdurch kann eine Ansteuerung der Haushaltgerätevorrichtung weiter vereinfacht werden, da insbesondere ein gleichzeitiger Betrieb von Diagonalinduktoren vermieden werden kann.

In einer besonders bevorzugten Ausgestaltung der Erfindung wird vorgeschlagen, dass in der Induktormatrix i,j-te Induktoren gleicher i oder gleicher j zueinander benachbart und vorzugsweise zueinander unmittelbar benachbart sind. Insbesondere sind die i,j-ten Induktoren gleicher i oder gleicher j in einer gleichen Zeile oder Spalte der Heizmatrix angeordnet. Insbesondere sind i,j-te Induktoren gleicher i oder j miteinander gruppiert angeordnet und bilden insbesondere zumindest teilweise, vorzugsweise zumindest zu einem Großteil und besonders bevorzugt vollständig zumindest eine Heizzone für ein Gargeschirr aus. Weiter bevorzugt bilden i,j-te Induktoren verschiedener i oder j zumindest teilweise verschiedene Heizzonen aus. Hierdurch kann eine Ansteuerung der Haushaltgerätevorrichtung weiter vereinfacht werden, da insbesondere ein gleichzeitiger Betrieb von zumindest zwei i,j-ten Induktoren, für welche i=j in der Heizmatrix gilt, besonders vorteilhaft vermieden werden kann.

Denkbar ist, dass die Gesamtanzahl N+M von Spaltenschaltelementen und Zeilenschaltelementen kleiner oder gleich der Anzahl N×M von Heizmatrixelementen ist. Um mit einer möglichst geringen Gesamtanzahl N+M von Spaltenschaltelementen und Zeilenschaltelementen eine Anzahl N×M von Heizmatrixelementen zu betreiben und vorteilhaft Bauteilkosten zu reduzieren, wird vorgeschlagen, dass die Anzahl N von Zeilenschaltelementen gleich der Anzahl M von Spaltenschaltelementen ist. Insbesondere ist die Heizmatrix dann als eine quadratische Matrix ausgebildet.

Um eine ungewollte Ansteuerung von zumindest zwei Diagonalinduktoren auszuschließen, wird vorgeschlagen, dass die Gesamtanzahl N+M von Spaltenschaltelementen und Zeilenschaltelementen um eins größer ist als die Anzahl N×M von Heizmatrixelementen. Für diesen Fall ist die Heizmatrix insbesondere als ein Vektor, vorzugsweise ein Zeilenvektor, insbesondere, wenn die Anzahl N der Zeilenschaltelemente gleich 1, oder als ein Spaltenvektor, insbesondere wenn die Anzahl M der Spaltenschaltelemente gleich 1 ist, ausgebildet.

Des Weiteren wird vorgeschlagen, dass das i,j-te Heizmatrixelement zumindest eine i,j-te Diode aufweist, mittels welcher der i,j-te Induktor zumindest mit dem i-ten Zeilenschaltelement verbunden ist. Insbesondere ist die i,j-te Diode an dem i,j-ten Anschluss zwischen dem i,j-ten Induktor und dem i-ten Zeilenschaltelement angeschlossen. Die i,j-te Diode erlaubt insbesondere einen Stromfluss in Richtung des i-ten Zeilenschaltelements und sperrt vorzugsweise einen Stromfluss in Richtung des i,j-ten Induktors. Insbesondere für den Fall, dass die Anzahl an Zeilenschaltelementen gleich 1 ist, kann auf die i,j-te Diode verzichtet werden. Zudem könnten insbesondere eine Rücklaufdiode und/oder ein Dämpfungskondensator der Haushaltsgerätevorrichtung parallel zu dem j-ten Spaltenschaltelement geschaltet sein. Weiter vorteilhaft weist das i,j-te Heizmatrixelement zumindest eine i,j-te weitere Diode auf, mittels welcher der i,j-te Induktor zumindest mit dem j-ten Spaltenschaltelement verbunden ist. Insbesondere ist die i,j-te weitere Diode an dem i,j-ten Anschluss zwischen dem i,j-ten Induktor und dem j-ten Spaltenschaltelement angeschlossen. Die i,j-te Diode erlaubt insbesondere einen Stromfluss in Richtung des i,j-ten Induktors und sperrt vorzugsweise einen Stromfluss in Richtung des j-ten Spaltenschaltelements. Ferner kann für den Fall, dass die Anzahl M an Spaltenschaltelementen gleich 1 ist, auf die weitere i,j-te Diode verzichtet werden. Zudem könnten insbesondere eine Rücklaufdiode und/oder ein Dämpfungskondensator parallel zu dem i-ten Zeilenschaltelement geschaltet sein. Hierdurch kann insbesondere ein unkontrollierter Stromfluss insbesondere zwischen mehreren Heizmatrixelementen vermieden werden.

Es wird ferner vorgeschlagen, dass das i,j-te Heizmatrixelement zumindest eine i,j-te Kapazität aufweist, mittels welcher der i,j-te Induktor mit zumindest einem den Heizmatrixelementen gemeinsamen Referenzpotential verbunden ist. Das den Heizmatrixelementen gemeinsame Referenzpotential ist insbesondere das Betriebspotential. Ferner weist das i,j-te Heizmatrixelement insbesondere zumindest eine i,j-te weitere Kapazität auf, mittels welcher der i,j-te Induktor mit zumindest einem den Heizmatrixelementen gemeinsamen weiteren Referenzpotential verbunden ist. Das den Heizmatrixelementen gemeinsame weitere Referenzpotential ist insbesondere das weitere Betriebspotential. Die i,j-te Kapazität umfasst zumindest einen Kondensator. Vorzugsweise kann die Kapazität mehrere Kondensatoren, insbesondere ein Kondensatornetzwerk, umfassen, welches vorzugsweise aus zumindest teilweise zueinander in Reihe geschalteten und/oder parallel geschalteten Kondensatoren besteht. Ferner kann die Kapazität insbesondere einstellbar sein. Der i,j-te Induktor weist insbesondere zumindest einen i,j-ten weiteren Anschluss auf, welcher sowohl mit der i,j-ten Kapazität als auch mit der i,j-ten weiteren Kapazität verbunden ist. Hierdurch kann vorteilhaft eine Eigenfrequenz eines Schwingkreises der Haushaltsgerätevorrichtung durch eine entsprechende Wahl der Kapazitäten auf den Anwendungsbereich abgestimmt werden.

Weiterhin wird vorgeschlagen, dass die Heizmatrix eine Anzahl N von Zeilendioden umfasst, wobei die i-te Zeilendiode zumindest das i-te Zeilenschaltelement mit zumindest einem den Zeilenschaltelementen gemeinsamen weiteren Referenzpotential, insbesondere dem weiteren Betriebspotential, verbindet. Es wird ferner vorgeschlagen, dass die Heizmatrix eine Anzahl M von Spaltendioden umfasst, wobei die j-te Spaltendiode zumindest das j-te Spaltenschaltelement mit zumindest einem für die Spaltenschaltelemente gemeinsamen Referenzpotential, insbesondere dem Betriebspotential, verbindet. Hierdurch kann ein besonders weicher Schaltvorgang erreicht werden.

Es wird ferner vorgeschlagen, dass die Steuereinheit in zumindest einem Gargeschirrerkennungsmodus dazu vorgesehen ist, wenn eine Betriebsspannung einen zumindest im Wesentlichen verschwindend geringen Wert annimmt, zumindest eine an zumindest einem der Induktoren auftretende elektrische Kenngröße zu ermitteln. Die elektrische Kenngröße ist vorzugsweise mit einer elektromagnetischen Kopplung des Induktors mit einem Gargeschirr, und zwar insbesondere mit einem Überdeckungsgrad und/oder einem Material des Gargeschirrs, korreliert. Insbesondere kann die Steuereinheit wenigstens anhand der elektrischen Kenngröße auf die elektromagnetische Kopplung des Induktors mit dem Gargeschirr schließen und vorzugsweise diese bestimmen. Die elektrische Kenngröße entspricht insbesondere einer direkten Steuergröße. Vorteilhaft handelt es sich bei der elektrische Kenngröße um ein, insbesondere von einer Sensoreinheit der Haushaltsgerätevorrichtung gemessenes, elektrisches Signal und/oder elektronisches Signal. Vorzugsweise ist die elektrische Kenngröße eine Frequenz, Amplitude und/oder Phase einer Spannung, welche an dem Induktor anliegt und/oder eines Stroms, welcher durch den Induktor fließt. Hierdurch kann eine Flexibilität der Haushaltsgerätevorrichtung verbessert werden, da Gargeschirre detektiert werden können.

Es wird ferner vorgeschlagen, dass die Steuereinheit in dem Gargeschirrerkennungsmodus dazu vorgesehen ist, den i,j-ten Induktor zuerst zu laden und anschließend, wenn eine Betriebsspannung einen zumindest im Wesentlichen verschwindend geringen Wert annimmt, wieder zu entladen. Vorteilhaft ist die Steuereinheit in dem Gargeschirrerkennungsmodus dazu vorgesehen, eine Kennlinie eines Entladevorgangs des i,j-ten Induktors zu erfassen und mittels dieser Kennlinie die elektrische Kenngröße zu ermitteln. Die Kennlinie ist insbesondere ein zeitlicher Verlauf der elektrischen Kenngröße. Insbesondere ist die Steuereinheit dazu vorgesehen, durch eine Anpassung einer Vergleichskennlinie an die Kennlinie, insbesondere basierend auf Parametern zur Erzeugung der Vergleichskennlinie, den elektrischen Kennwert zu bestimmen. Hierdurch kann auf einfache Art und Weise eine Entladung des Induktors erfolgen, wobei vermieden werden kann, dass ein Kurzschluss mit weiteren elektrischen Bauteilen entsteht.

Ferner wird ein Verfahren zum Betrieb einer Haushaltsgerätevorrichtung, insbesondere einer Gargerätevorrichtung, vorgeschlagen, welche zumindest einen Induktor und zumindest eine Schalteinheit umfasst, an welcher in zumindest einem Betriebszustand zumindest eine Betriebsspannung anliegt, wobei durch Schalten der Schalteinheit zumindest eine Versorgungsspannung für den Induktor bereitgestellt wird und in zumindest einem Betriebszustand zumindest eine Frequenz der Versorgungsspannung innerhalb zumindest einer Periode der Betriebsspannung variiert wird, wobei in dem Betriebszustand zusätzlich zumindest ein Tastgrad der Versorgungsspannung innerhalb der zumindest einen Periode der Betriebsspannung variiert wird.

Die Haushaltsgerätevorrichtung soll hierbei insbesondere nicht auf die oben beschriebene Anwendung und Ausführungsform beschränkt sein. Insbesondere kann die Haushaltsgerätevorrichtung zu einer Erfüllung einer hierin beschriebenen Funktionsweise eine von einer hierin genannten Anzahl von einzelnen Elementen, Bauteilen und Einheiten abweichende Anzahl aufweisen. Vorzugsweise sollen bei den in dieser Offenbarung angegebenen Wertebereichen auch innerhalb der genannten Grenzen liegende Werte als offenbart und als beliebig einsetzbar gelten.

Weitere Vorteile ergeben sich aus der folgenden Zeichnungsbeschreibung. In der Zeichnung sind Ausführungsbeispiele der Erfindung dargestellt.

Es zeigen:
- Fig. 1: ein Haushaltsgerät mit einer Haushaltsgerätevorrichtung in einer schematischen Draufsicht,
- Fig. 2: ein schematisches Schaltbild eines Teils der Haushaltsgerätevorrichtung mit einer Heizmatrix,
- Fig. 3: einen Teil der Haushaltsgerätevorrichtung mit einer Induktormatrix in einer schematischen Draufsicht,
- Fig. 4: einen schematischen Ablaufplan eines Verfahrens zum Betrieb der Haushaltsgerätevorrichtung mit einem Gargeschirrerkennungsmodus,
- Fig. 5: verschiedene Schaubilder mit typischen Strom- und/oder Spannungsverläufen bei einem Betrieb der Haushaltsgerätevorrichtung,
- Fig. 6: eine weitere Haushaltsgerätevorrichtung in einer schaltbildlichen Darstellung,
- Fig. 7: eine weitere Haushaltsgerätevorrichtung in einer schaltbildlichen Darstellung,
- Fig. 8: eine weitere Haushaltsgerätevorrichtung in einer schaltbildlichen Darstellung,
- Fig. 9: eine weitere Haushaltsgerätevorrichtung in einer schaltbildlichen Darstellung,
- Fig. 10: eine weitere Haushaltsgerätevorrichtung in einer schaltbildlichen Darstellung,
- Fig. 11: eine weitere Haushaltsgerätevorrichtung in einer schaltbildlichen Darstellung,
- Fig. 12: ein weiteres bevorzugtes Verfahren zur Steuerung der Haushaltsgerätevorrichtung und insbesondere der weiteren Haushaltsgerätevorrichtungen aus Fig. 6 bis11,
- Fig. 13a-b: verschiedene Schaubilder mit typischen Strom-, Spannungs- und Leistungsverläufen bei einer Steuerung der Haushaltsgerätevorrichtung gemäß dem Verfahren aus Fig. 12,
- Fig. 14: verschiedene Schaubilder mit weiteren Leistungsverläufen bei einer Steuerung der Haushaltsgerätevorrichtung gemäß dem Verfahren aus Fig. 12,
- Fig. 15: verschiedene Schaubilder mit weiteren Leistungsverläufen bei einer Steuerung der Haushaltsgerätevorrichtung gemäß dem Verfahren aus Fig. 12,
- Fig. 16a-d: verschiedene Schaubilder mit Leistungskennlinien eines ersten Gargeschirrs für eine Steuerung der Haushaltsgerätevorrichtung gemäß dem Verfahren aus Fig. 12,
- Fig. 17a-d: verschiedene Schaubilder mit Leistungskennlinien eines zweiten Gargeschirrs für eine Steuerung der Haushaltsgerätevorrichtung gemäß dem Verfahren aus Fig. 12,
- Fig. 18a-d: verschiedene Schaubilder mit Leistungskennlinien eines dritten Gargeschirrs für eine Steuerung der Haushaltsgerätevorrichtung gemäß dem Verfahren aus Fig. 12 und
- Fig. 19: eine weitere Haushaltsgerätevorrichtung in einer schaltbildlichen Darstellung, welche zu eine Ausführung des Verfahren aus Fig. 12 vorgesehen ist.

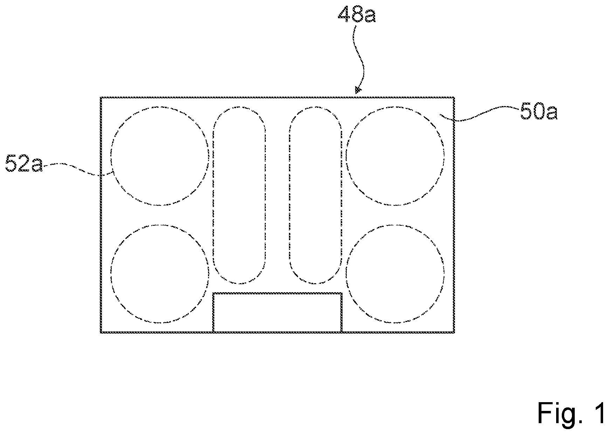

Fig. 1 zeigt ein Haushaltsgerät 48a mit einer Haushaltsgerätevorrichtung in einer schematischen Draufsicht. Das Haushaltsgerät 48a ist im vorliegenden Fall als ein Gargerät ausgebildet. Das Haushaltsgerät 48a ist ein Kochfeld, und zwar insbesondere ein variables Induktionskochfeld. Alternativ kann das Haushaltsgerät 48a als ein beliebiges, von einem Kochfeld verschiedenes und insbesondere einem Fachmann als vorteilhaft erscheinendes Haushaltsgerät 48a, insbesondere Gargerät, ausgebildet sein, wie beispielsweise als eine Mikrowelle oder ein Induktionsbackofen.

Die Haushaltsgerätevorrichtung weist eine Kochfeldplatte 50a auf. Die Haushaltsgerätevorrichtung ist dazu vorgesehen, zumindest ein Gargeschirr, welches an einer beliebigen Position auf der Kochfeldplatte 50a angeordnet ist, zu betreiben. Die Kochfeldplatte 50a umfasst bevorzugte Heizzonenpositionen 52a, welche bevorzugte Positionen für Gargeschirre kennzeichnen. Im vorliegenden Fall weist die Kochfeldplatte 50a sechs bevorzugte Heizzonenpositionen 52a auf. Zur besseren Übersicht ist nur eine der bevorzugten Heizzonenpositionen 52a mit einem Bezugszeichen versehen. Die Kochfeldplatte 50a kann insbesondere eine beliebige Anzahl an bevorzugten Heizzonenpositionen 52a oder auch keine bevorzugten Heizzonenpositionen 52a aufweisen.

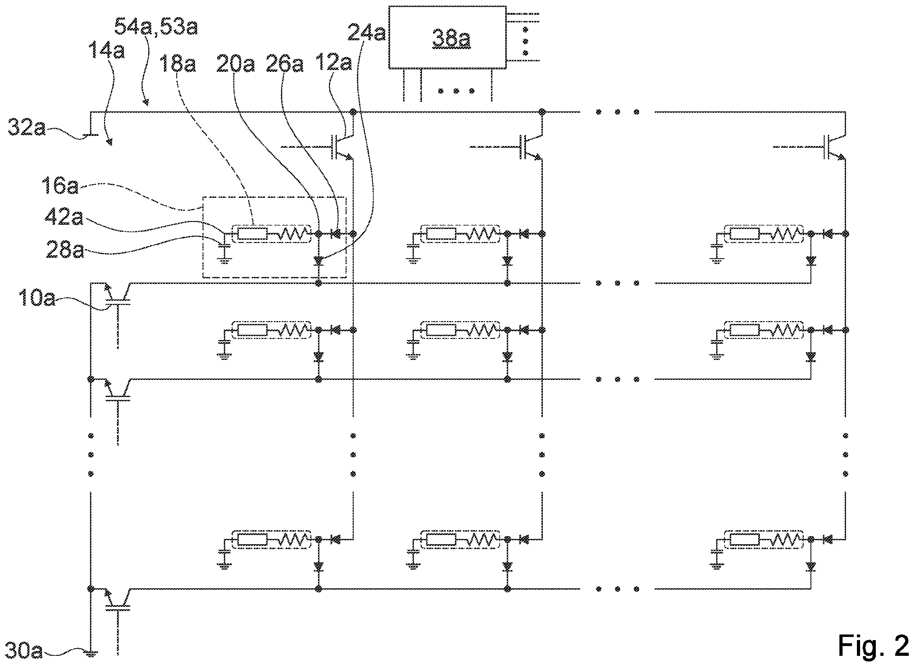

Fig. 2 zeigt ein schematisches Schaltbild eines Teils der Haushaltsgerätevorrichtung. Die Haushaltsgerätevorrichtung umfasst zumindest eine Anzahl N von Zeilenschaltelementen 10a. Ferner umfasst die Haushaltsgerätevorrichtung zumindest eine Anzahl M von Spaltenschaltelementen 12a. Die Haushaltsgerätevorrichtung umfasst zumindest eine Heizmatrix 14a. Die Heizmatrix 14a weist für beliebige i von 1 bis N und beliebige j von 1 bis M zumindest ein i,j-tes Heizmatrixelement 16a auf. Die Heizmatrix 14a weist eine Anzahl N×M von Heizmatrixelementen 16a auf. Eine Gesamtanzahl N+M von Zeilenschaltelementen 10a und Spaltenschaltelementen 12a ist größer als 2. Die Gesamtanzahl N+M von Zeilenschaltelementen 10a und Spaltenschaltelementen 12a ist kleiner oder gleich der Anzahl N×M von Heizmatrixelementen 16a. Im vorliegenden Fall weist die Haushaltsgerätevorrichtung eine Anzahl N von =8 Zeilenschaltelementen 10a auf. Im vorliegenden Fall weist die Haushaltsgerätevorrichtung eine Anzahl M von =3 Spaltenschaltelementen 12a auf. Zudem weist die Haushaltsgerätevorrichtung eine Anzahl von N×M=24 Heizmatrixelementen 16a auf. Es ist jedoch auch denkbar, dass N und/oder M eine beliebige andere natürliche Zahl sein kann, welche von einem Fachmann als besonders vorteilhaft angesehen wird. Alternativ oder zusätzlich kann eine Anzahl N gleich einer Anzahl M gewählt sein oder so, dass die Gesamtanzahl N+M um eins größer ist als die Anzahl N×M.

Im Folgenden ist beispielhaft anhand i-ter, j-ter und i,j-ter elektrischer Bauteile der Haushaltsgerätevorrichtung eine, insbesondere schaltbildliche, Anordnung der elektrischen Bauteile der Haushaltsgerätevorrichtung erläutert. Dabei können die folgenden Erläuterungen auf weitere, äquivalente elektrische Bauteile übertragen werden.

Das i-te Zeilenschaltelement 10a ist als ein Transistor ausgebildet. Das i-te Zeilenschaltelement 10a weist einen ersten Anschluss auf. Der erste Anschluss ist ein Source-Anschluss. Der erste Anschluss des i-te Zeilenschaltelements 10a ist mit dem i,j-ten Heizmatrixelement 16a verbunden. Das i-te Zeilenschaltelement 10a weist einen zweiten Anschluss auf. Der zweite Anschluss ist ein Drain-Anschluss. Der zweite Anschluss des i-ten Zeilenschaltelements 10a ist mit einem den Zeilenschaltelementen 10a gemeinsamen Referenzpotential 30a verbunden. Das den Zeilenschaltelementen 10a gemeinsame Referenzpotential 30a ist ein Betriebspotential einer Betriebsspannung und zwar vorzugsweise ein Massepotential. Die Haushaltsgerätevorrichtung weist insbesondere einen Gleichrichter auf, welcher eine Netzspannung in die Betriebsspannung wandelt. Die Betriebsspannung ist dabei die Spannung, welche zwischen dem den Zeilenschaltelementen 10a gemeinsamen Referenzpotential 30a und einem den Spaltenschaltelementen 12a gemeinsamen weiteren Referenzpotential 32a anliegt. Das i-te Zeilenschaltelement 10a weist einen Steueranschluss auf. Der Steueranschluss ist ein Gate-Anschluss. Der Steueranschluss ist mit einer Steuereinheit 38a der Haushaltsgerätevorrichtung verbunden.

Das j-te Spaltenschaltelement 12a ist als ein Transistor ausgebildet. Das j-te Spaltenschaltelement 12a weist einen ersten Anschluss auf. Der erste Anschluss ist ein Source-Anschluss. Der erste Anschluss des j-ten Spaltenschaltelements 12a ist mit dem den Spaltenschaltelementen 12a gemeinsamen weiteren Referenzpotential 32a verbunden. Das den Spaltenschaltelementen 12a gemeinsame weitere Referenzpotential 32a ist das weitere Betriebspotential. Das j-te Spaltenschaltelement 12a weist einen zweiten Anschluss auf. Der zweite Anschluss ist ein Drain-Anschluss. Der zweite Anschluss des j-ten Spaltenschaltelements 12a ist mit dem i,j-ten Heizmatrixelement 16a verbunden. Das j-te Spaltenschaltelement 12a weist einen Steueranschluss auf. Der Steueranschluss ist ein Gate-Anschluss. Der Steueranschluss ist mit der Steuereinheit 38a der Haushaltsgerätevorrichtung verbunden.

Das i-te Zeilenschaltelement 10a und das j-te Spaltenschaltelement 12a sind in einer Halbbrücken-Topologie angeordnet. Es ist denkbar, dass die Haushaltsgerätevorrichtung i-te weitere Zeilenschaltelemente 10a und j-te weitere Spaltenschaltelemente 12a umfasst, so dass die i-ten Zeilenschaltelemente 10a, die i-ten weiteren Zeilenschaltelemente 10a, die j-ten Spaltenschaltelemente 12a und die j-ten weiteren Spaltenschaltelemente 12a in einer Vollbrücken-Topologie angeordnet sein können.

Das i-te Zeilenschaltelement 10a und das j-te Spaltenschaltelement 12a dienen als Wechselrichterschaltelemente. Das i-te Zeilenschaltelement 10a und das j-te Spaltenschaltelement 12a bilden gemeinsam zumindest eine i,j-te Wechselrichtereinheit 54a der Haushaltsgerätevorrichtung aus. Die Haushaltsgerätevorrichtung umfasst insbesondere eine Anzahl N×M Wechselrichtereinheiten 54a. Die Steuereinheit 38a ist dazu vorgesehen, das i-te Zeilenschaltelement 10a und das j-te Spaltenschaltelement 12a als Wechselrichterschaltelemente anzusteuern. Die Steuereinheit 38a steuert das i-te Zeilenschaltelement 10a und das j-te Spaltenschaltelement 12a so an, dass ein weicher Schaltvorgang zwischen zumindest einem ersten Schaltzustand und einem zweiten Schaltzustand des i-ten Zeilenschaltelements 10a und des j-ten Spaltenschaltelements 12a auftritt.

Das i,j-te Heizmatrixelement 16a weist zumindest einen i,j-ten Induktor 18a auf. Der i,j-te Induktor 18a ist sowohl mit dem i-ten Zeilenschaltelement 10a als auch mit dem j-ten Spaltenschaltelement 12a verbunden. Der i,j-te Induktor 18a weist zumindest einen i,j-ten Anschluss 20a auf. Der i,j-te Anschluss 20a ist sowohl mit dem i-ten Zeilenschaltelement 10a, insbesondere dem ersten Anschluss des i-ten Zeilenschaltelements 10a, als auch mit dem j-ten Spaltenschaltelement 12a, insbesondere mit dem zweiten Anschluss des j-ten Spaltenschaltelements 12a, verbunden. In der Heizmatrix 14a sind insgesamt N×M Induktoren 18a schaltbildlich angeordnet.

Das i,j-te Heizmatrixelement 16a weist zumindest eine i,j-te Diode 24a auf. Mittels der i,j-ten Diode 24a ist der i,j-te Induktor 18a zumindest mit dem i-ten Zeilenschaltelement 10a verbunden. Ein erster Anschluss der i,j-ten Diode 24a ist mit dem i,j-ten Anschluss 20a des i,j-ten Induktors 18a verbunden. Ein zweiter Anschluss der i,j-ten Diode 24a ist mit einem ersten Anschluss des i-ten Zeilenschaltelements 10a verbunden. Die i,j-te Diode 24a erlaubt einen Stromfluss in Richtung des i-ten Zeilenschaltelements 10a. Die i,j-te Diode 24a sperrt einen Stromfluss in Richtung des i,j-ten Induktors 18a.

Das i,j-te Heizmatrixelement 16a weist zumindest eine i,j-te weitere Diode 26a auf. Mittels der i,j-ten weiteren Diode 26a ist der i,j-te Induktor 18a zumindest mit dem j-ten Spaltenschaltelement 12a verbunden. Ein erster Anschluss der i,j-ten weiteren Diode 26a ist mit dem i,j-ten Anschluss 20a des i,j-ten Induktors 18a verbunden. Ein zweiter Anschluss der i,j-ten weiteren Diode 26a ist mit dem zweiten Anschluss des j-ten Spaltenschaltelements 12a verbunden. Die i,j-te weitere Diode 26a erlaubt einen Stromfluss in Richtung des i,j-ten Induktors 18a. Die i,j-te weitere Diode 26a sperrt einen Stromfluss in Richtung des j-ten Spaltenschaltelements 12a.

Das i,j-te Heizmatrixelement 16a weist zumindest eine i,j-te Kapazität 28a auf. Die i,j-te Kapazität 28a ist ein Kondensator. Mittels der i,j-ten Kapazität 28a ist der i,j-te Induktor 18a zumindest mit einem den Heizmatrixelementen 16a gemeinsamen Referenzpotential 30a verbunden. Das den Heizmatrixelementen 16a gemeinsame Referenzpotential 30a ist das Betriebspotential. Ein erster Anschluss der i,j-ten Kapazität 28a ist mit einem i,j-ten weiteren Anschluss 42a des i,j-ten Induktors 18a verbunden. Ein zweiter Anschluss der i,j-ten Kapazität 28a ist mit dem gemeinsamen Referenzpotential 30a verbunden.

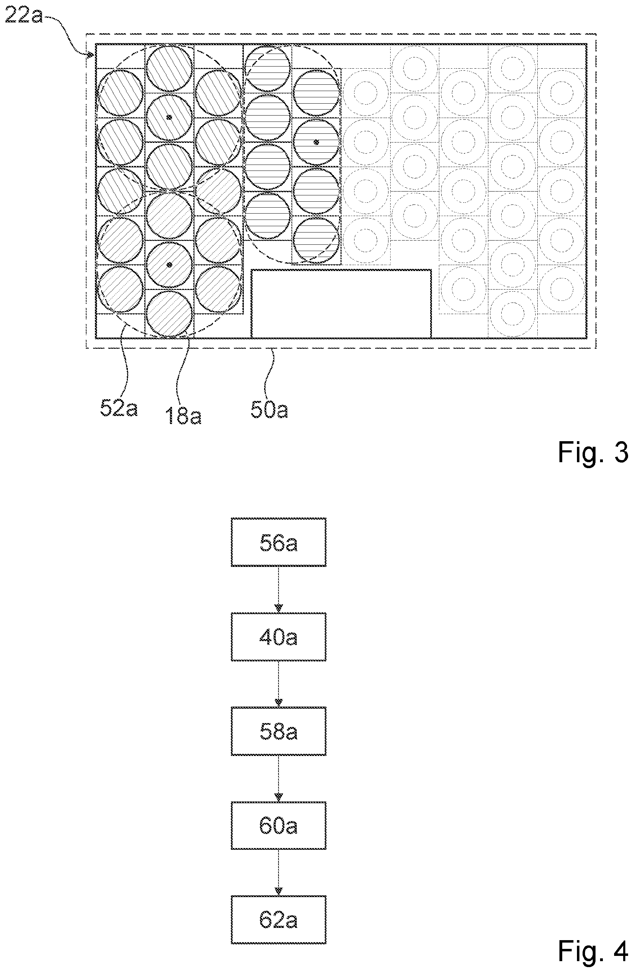

In Fig. 3 ist eine Draufsicht auf einen Teil der Haushaltsgerätevorrichtung mit einer Induktormatrix 22a gezeigt. Im vorliegenden Fall sind i,j-te Induktor 18a gleicher i in der Fig. 3 mit einer gleichen Schraffur versehen. Induktoren 18a, für welche i=j in der Heizmatrix 14a gilt, sind zusätzlich mit einem Punkt markiert. Die i,j-ten Induktoren 18a sind räumlich in der Induktormatrix 22a angeordnet. Die Induktormatrix 22a ist bezüglich von Nachbarschaftsverhältnissen von zumindest zwei der i,j-ten Induktoren 18a relativ zueinander verschieden von der Heizmatrix 14a. In der Induktormatrix 22a sind i,j-te Induktoren 18a gleicher i oder j zueinander benachbart. In der Induktormatrix 22a sind die i,j-ten Induktoren 18a räumlich so angeordnet, dass zumindest ein i,j-ter Induktor 18a, für welchen i=j in der Heizmatrix 14a gilt, zu zumindest einem i,j-ten Induktor 18a benachbart ist, für welchen i≠j in der Heizmatrix 14a gilt. Ein i,j-ter Induktor 18a, für welchen i=j in der Heizmatrix 14a gilt, ist von mehreren, insbesondere von zumindest drei, vorzugsweise von zumindest vier und besonders bevorzugt von zumindest fünf, i,j-ten Induktoren 18a, für welche i≠j in der Heizmatrix 14a gilt, umgeben, vorzugsweise ringförmig umgeben.

Fig. 4 zeigt ein Verfahren zur Steuerung der Haushaltsgerätevorrichtung. Im vorliegenden Fall wird das Verfahren anhand eines beispielhaften Betriebs der elektrischen Bauteile mit den Indizes i=1 und i=2, sowie der elektrischen Bauteile mit den Indizes j=1 und j=2 beschrieben. Das Verfahren kann äquivalent auf die beliebigen weiteren i-ten elektrischen Bauteile und j-ten elektrischen Bauteile übertragen werden.

Das Verfahren umfasst einen Betriebsschritt 56a. In dem Betriebsschritt 56a steuert die Steuereinheit 38a das 2-te Zeilenschaltelement 10a und das 1-te Spaltenschaltelement 12a als Wechselrichterschaltelemente an. Das 2-te Zeilenschaltelement 10a und das 1-te Spaltenschaltelement 12a gehen abwechselnd durch einen Schaltvorgang von einem ersten Schaltzustand in einen zweiten Schaltzustand über. Das 2-te Zeilenschaltelement 10a und das 1-te Spaltenschaltelement 12a verbinden das 2,1-te Heizmatrixelement 16a, insbesondere den 2,1-ten Induktor 18a, abwechselnd mit dem den Zeilenschaltelementen 10a gemeinsamen Referenzpotential 30a und dem den Spaltenschaltelementen 12a gemeinsamen weiteren Referenzpotential 32a. Das 2-te Zeilenschaltelement 10a und das 1-te Spaltenschaltelement 12a erzeugen eine Versorgungsspannung, mit welcher das 2,1-te Heizmatrixelement 16a, insbesondere der 2,1-te Induktor 18a, betrieben wird. Durch das 2,1-te Heizmatrixelement 16a, insbesondere den 2,1-ten Induktor 18a, fließt ein Heizstrom.

Das Verfahren umfasst einen Gargeschirrerkennungsmodus 40a. Der Gargeschirrerkennungsmodus 40a läuft zeitlich gemeinsam mit dem Betriebsschritt 56a ab. Alternativ kann der Gargeschirrerkennungsmodus 40a unabhängig von dem Betriebsschritt 56a erfolgen. Der Gargeschirrerkennungsmodus 40a umfasst einen Ladeschritt 58a. In dem Ladeschritt 58a steuert die Steuereinheit 38a das 1-te Spaltenschaltelement 12a so an, dass dieses in einen ersten Schaltzustand übergeht. Das 1,1-te Heizmatrixelement 16a, insbesondere die 1,1-te Kapazität 28a, wird mittels des 1-ten Spaltenschaltelements 12a auf das den Spaltenschaltelementen 12a gemeinsame weitere Referenzpotential 32a geladen. Die Steuereinheit 38a steuert das 1-te Zeilenschaltelement 10a so an, dass sich dieses in einem zweiten Schaltzustand befindet und somit keine leitende Verbindung mit dem den Zeilenschaltelementen 10a gemeinsamen Referenzpotential 30a herstellt. Es fließt kein Strom, wodurch die aufgeladene Spannung erhalten bleibt. In gleicher Weise wird das 2,2-te Heizmatrixelement 16a, insbesondere die 2,2-te Kapazität 28a, mit dem vom 2-ten Zeilenschaltelement 10a zur Verfügung gestellten, den Zeilenschaltelementen 10a gemeinsamen Referenzpotential 30a geladen. In dem Ladeschritt 58a steuert die Steuereinheit 38a das 2-te Zeilenschaltelement 10a an, so dass dieses in einen zweiten Schaltzustand übergeht. Das 2,2-te Heizmatrixelement 16a, insbesondere die 2,2-te Kapazität 28a, wird auf das den Zeilenschaltelementen 10a gemeinsame Referenzpotential 30a geladen. Die Steuereinheit 38a steuert das 2-te Spaltenschaltelement 12a so an, dass sich dieses in dem zweiten Schaltzustand befindet und somit keine leitende Verbindung zu dem den Spaltenschaltelementen 12a gemeinsamen weiteren Referenzpotential 32a hergestellt wird. Es fließt kein Strom, wodurch die aufgeladene Spannung erhalten bleibt.

Der Gargeschirrerkennungsmodus 40a umfasst einen Entladeschritt 60a. Der Entladeschritt 60a wird während des Betriebsschritts 56a durchgeführt. Die Betriebsspannung, welche zwischen dem 2-ten Zeilenschaltelement 10a und dem 1-ten Spaltenschaltelement 12a anliegt, variiert mit der Zeit. Nimmt die Betriebsspannung einen zumindest im Wesentlichen verschwindend geringen Wert an, wird der Entladeschritt 60a durchgeführt. Die Steuereinheit 38a entlädt das 1,1-te Heizmatrixelement 16a. Dazu schaltet die Steuereinheit 38a das 1-te Zeilenschaltelement 10a in den ersten Schaltzustand. Das 1-te Zeilenschaltelement 10a verbindet das 1,1-te Heizmatrixelement 16a, insbesondere die 1,1-te Kapazität 28a, mit dem den Zeilenschaltelementen 10a gemeinsamen Referenzpotential 30a. Das 1,1-te Heizmatrixelement 16a, insbesondere die 1,1-te Kapazität 28a, entlädt sich. Es wird eine Kennlinie 46a des Entladevorgangs erfasst. Es wird eine weitere Kennlinie 47a des Entladevorgangs erfasst.

Der Gargeschirrerkennungsmodus 40a umfasst einen Bestimmungsschritt 62a. In dem Bestimmungsschritt 62a wird eine Vergleichskennlinie an die im Entladeschritt 60a erfasste Kennlinie 46a und insbesondere die weitere Kennlinie 47a angepasst. Aus Parametern der Vergleichskennlinie wird eine Güte einer elektromagnetischen Kopplung bestimmt. Aus der Güte der elektromagnetischen Kopplung wird ferner ein Überdeckungsgrad zwischen dem 1,1-ten Induktor 18a und einem mit dem 1,1-ten Induktor 18a gekoppelten Gargeschirr und/oder ein Material des Gargeschirrs bestimmt.

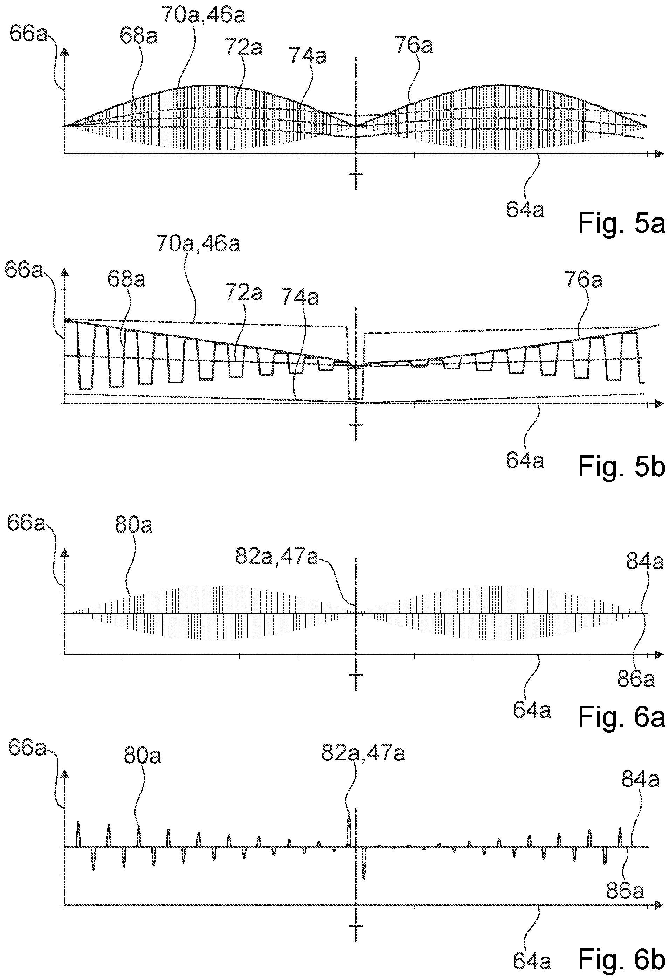

Fig. 5a zeigt ein Schaubild des Verfahrens zur Steuerung der Haushaltsgerätevorrichtung. Auf einer Abszissenachse 64a ist eine Zeit aufgetragen. Auf einer Ordinatenachse 66a ist eine Spannung aufgetragen. Eine erste Spannungskurve 68a zeigt einen zeitlichen Verlauf der Versorgungsspannung, welche an dem 2,1-ten Heizmatrixelement 16a anliegt. Eine zweite Spannungskurve 70a zeigt einen zeitlichen Verlauf einer Spannung, welche an dem 1,1-ten Heizmatrixelement 16a anliegt. Eine dritte Spannungskurve 72a zeigt einen zeitlichen Verlauf einer Spannung, welche an dem 1,2-ten Heizmatrixelement 16a anliegt. Eine vierte Spannungskurve 74a zeigt einen zeitlichen Verlauf einer Spannung, welche an dem 2,2-ten Heizmatrixelement 16a anliegt. Eine fünfte Spannungskurve 76a zeigt einen zeitlichen Verlauf der Betriebsspannung. In Fig. 5b sind die Kurven 68a, 70a, 72a, 74a, 76a nochmals dargestellt. In Fig. 5b ist ein Bereich des Schaubilds der Fig. 5a um einen Zeitpunkt T gezeigt, an welchem die Betriebsspannung einen zumindest im Wesentlichen verschwindend geringen Wert annimmt. In Fig.5b weist die Abszissenachse 64a eine feinere Skalierung auf als in Fig. 5a.

Fig. 6a zeigt ein Schaubild des Verfahrens zur Steuerung der Haushaltsgerätevorrichtung. Auf einer Abszissenachse 64a ist eine Zeit aufgetragen. Auf einer Ordinatenachse 66a ist ein Strom aufgetragen. Eine erste Stromkurve 80a zeigt einen zeitlichen Verlauf des Heizstroms, welcher durch das 2,1-te Heizmatrixelement 16a fließt. Eine zweite Stromkurve 82a zeigt einen zeitlichen Verlauf eines Stroms, welcher durch das 1,1-te Heizmatrixelement 16a fließt. Eine dritte Stromkurve 84a zeigt einen Strom, welcher durch das 1,2-te Heizmatrixelement 16a fließt. Eine vierte Stromkurve 86a zeigt einen Strom, welcher durch das 2,2-te Heizmatrixelement 16a fließt. In Fig. 6b ist ein Bereich des Schaubilds der Fig. 6a um einen Zeitpunkt T gezeigt, an welchem die Betriebsspannung einen zumindest im Wesentlichen verschwindend geringen Wert annimmt. In Fig.6b weist die Abszissenachse 64a eine feinere Skalierung auf als in Fig. 6a.

Die zweite Stromkurve 82a und die zweite Spannungskurve 70a zeigen den Ladeschritt 58a des 1,1-ten Heizmatrixelements 16a. In dem Ladeschritt 58a wird das 1,1-te Heizmatrixelement 16a mit dem den Spaltenschaltelementen 12a gemeinsamen weiteren Referenzpotential 32a geladen. Im Entladeschritt 60a wird, sobald die Betriebsspannung, die fünfte Spannungskurve 76a, einen zumindest im Wesentlichen verschwindenden Wert annimmt, das 1,1-te Heizmatrixelement 16a entladen. Es fließt ein Strom, welcher der zweiten Stromkurve 82a entspricht. Die zweite Spannungskurve 70a wird erfasst. Die zweite Spannungskennlinie dient als eine Kennlinie 46a zur Ermittlung der elektrischen Kenngröße. Die zweite Stromkurve 82a wird erfasst. Die zweite Stromkurve 82a dient als weitere Kennlinie 47a zur Ermittlung der elektrischen Kenngröße.

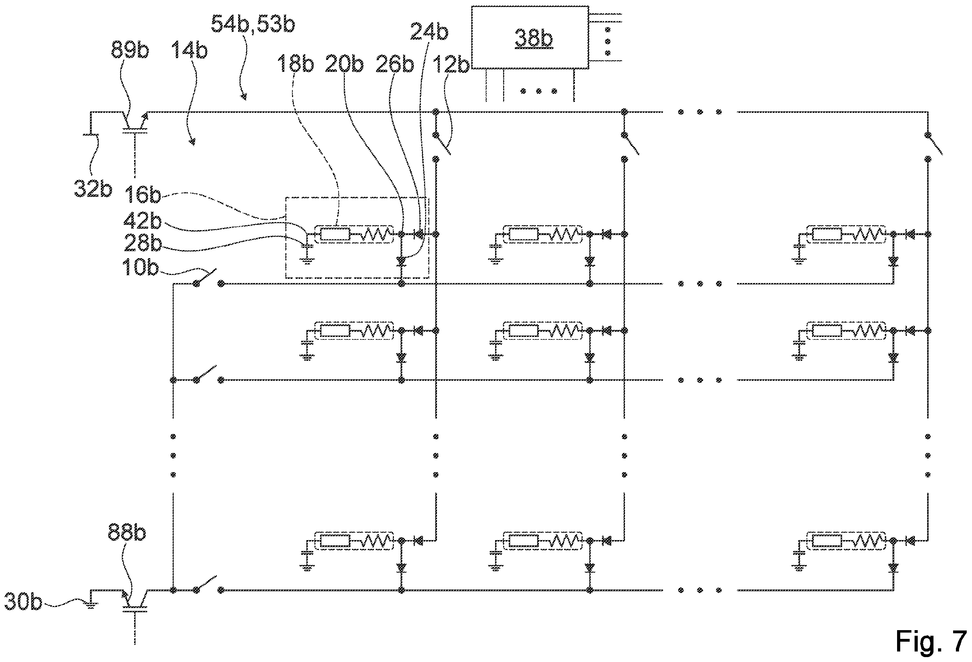

In den Fig. 7 bis 11 und 19 sind weitere Ausführungsbeispiele der Erfindung gezeigt. Die nachfolgende Beschreibung und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnung und/oder die Beschreibung der anderen Ausführungsbeispiele, insbesondere der Figuren 1 bis 6, verwiesen werden kann. Zur Unterscheidung der Ausführungsbeispiele ist der Buchstabe a den Bezugszeichen des Ausführungsbeispiels in den Figuren 1 bis 6 nachgestellt. In den Ausführungsbeispielen der Fig.7 bis 11 und 19 ist der Buchstabe a durch die Buchstaben b bis f und g ersetzt.

Fig. 7 zeigt ein Schaltbild eines weiteren Ausführungsbeispiels der Erfindung. Das weitere Ausführungsbeispiel unterscheidet sich von dem vorherigen Ausführungsbeispiel zumindest im Wesentlichen hinsichtlich einer Anzahl N und einer Anzahl M. Im vorliegenden Fall ist eine Anzahl N von Zeilenschaltelementen 10b gleich der Anzahl M von Spaltenschaltelementen 12b. Ferner ist die Gesamtanzahl N+M von Zeilenschaltelementen 10b und Spaltenschaltelementen 12b kleiner oder gleich der Anzahl N×M von Heizmatrixelementen 16b. Im vorliegenden Fall ist die Anzahl N=4 und die Anzahl M=4. Im vorliegenden Fall ist/sind zumindest das i-te Zeilenschaltelement 10b, insbesondere alle Zeilenschaltelemente 10b, und/oder zumindest das j-te Spaltenschaltelement 12b, insbesondere alle Spaltenschaltelemente 12b, als Schalter, vorzugsweise Relais, ausgebildet. Ferner weist die Haushaltsgerätevorrichtung eine zusätzliche Wechselrichtereinheit 54b auf. Die Wechselrichtereinheit 54b weist ein erstes Wechselrichterelement 88b auf. Ferner weist die Wechselrichtereinheit 54b ein zweites Wechselrichterelement 89b auf. Die Wechselrichterelemente 88b, 89b sind als Transistoren ausgebildet. Das Wechselrichterelement 88b verbindet die Zeilenschaltelemente 10b mit einem den Zeilenschaltelementen 10b gemeinsamen Referenzpotential 30b. Das weitere Wechselrichterelement 89b verbindet die Spaltenschaltelemente 12b mit einem den Spaltenschaltelementen 12b gemeinsamen weiteren Referenzpotential 32b.

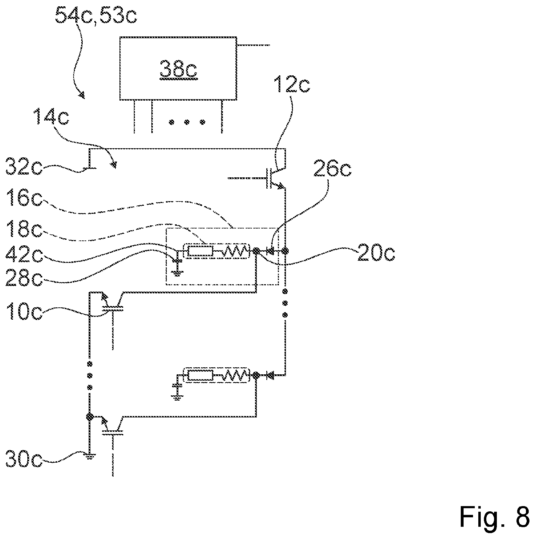

Fig. 8 zeigt ein Schaltbild eines weiteren Ausführungsbeispiels der Erfindung. Das weitere Ausführungsbeispiel unterscheidet sich von dem vorherigen Ausführungsbeispiel zumindest im Wesentlichen hinsichtlich einer Anzahl N und M. Eine Gesamtanzahl N+M von Zeilenschaltelementen 10c und Spaltenschaltelementen 12c ist um eins größer ist als eine Anzahl N×M von Heizmatrixelementen 16c. Im vorliegenden Fall ist die Anzahl N=2 und die Anzahl M=1. Eine Heizmatrix 14c bildet einen schaltbildlichen Vektor aus. Bei einer Ausgestaltung, für die gilt, dass die Gesamtanzahl N+M um eins größer ist als die Anzahl N, kann auf i, 1-te Dioden 24c verzichtet werden. Ein erster Anschluss des i-ten Zeilenschaltelement 10c ist mit einem i,j-ten Anschluss 20c eines i,j-ten Induktors 18c verbunden.

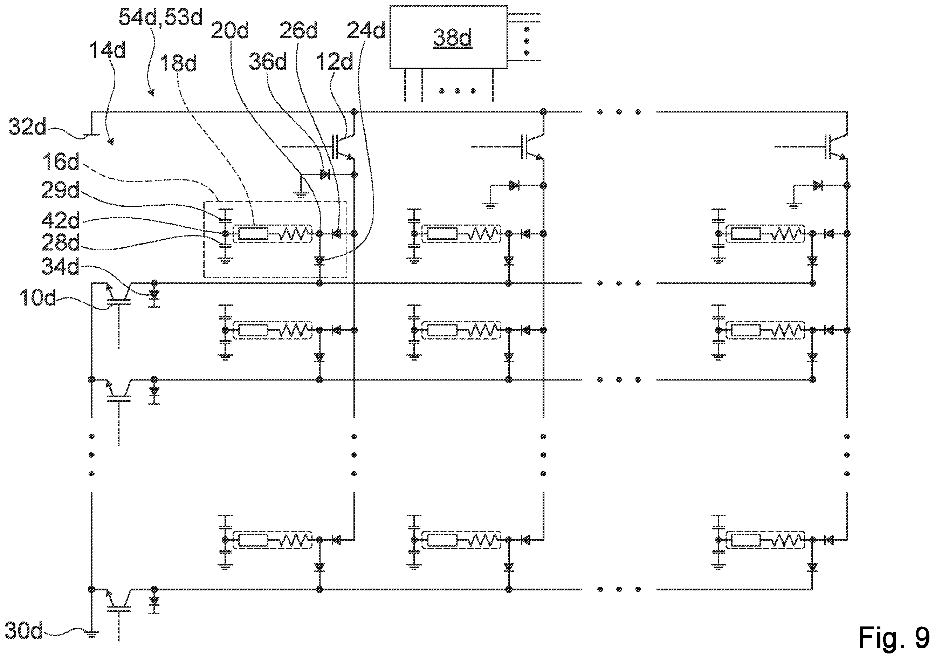

Fig.9 zeigt ein weiteres Ausführungsbeispiel der Erfindung. Das weitere Ausführungsbeispiel unterscheidet sich von dem vorherigen Ausführungsbeispiel zumindest im Wesentlichen hinsichtlich weiterer elektrischer Bauteile der Haushaltsgerätevorrichtung. Die Haushaltsgerätevorrichtung weist eine Anzahl M von Spaltendioden 36d auf. Die j-te Spaltendiode 36d verbindet zumindest ein j-tes Spaltenschaltelement 12d mit zumindest einem den Spaltenschaltelementen 12d gemeinsamen Referenzpotential 30d. Das den Spaltenschaltelementen 12d gemeinsame Referenzpotential 30d ist gleich einem den Zeilenschaltelementen 10d gemeinsamen Referenzpotential 30d. Ein erster Anschluss des j-ten Spaltenschaltelements 12d ist mit einem den Spaltenschaltelementen 12d gemeinsamen weiteren Referenzpotential 32d verbunden. Ein zweiter Anschluss des j-ten Spaltenschaltelements 12d ist mit einem ersten Anschluss einer j-ten Spaltendiode 36d verbunden. Die j-te Spaltendiode 36d sperrt einen Strom in Richtung des den Spaltenschaltelementen 12d gemeinsamen Referenzpotentials 30d. Die j-te Spaltendiode 36d lässt einen Strom aus Richtung des den Spaltenschaltelementen 12d gemeinsamen Referenzpotentials 30d zu.

Die Haushaltsgerätevorrichtung weist eine Anzahl N von Zeilendioden 34d auf. Die i-te Zeilendiode 34d verbindet zumindest ein i-tes Zeilenschaltelement 10d mit zumindest einem den Zeilenschaltelementen 10d gemeinsamen weiteren Referenzpotential 32d. Das den Zeilenschaltelementen 10d gemeinsamen weitere Referenzpotential 32d ist eine weitere Betriebsspannung. Das den Zeilenschaltelementen 10d gemeinsamen weiteren Referenzpotential 32d ist gleich dem den Spaltenschaltelementen 12d gemeinsame weitere Referenzpotential 32d. Ein erster Anschluss der i-ten Zeilendiode 34d ist mit einem ersten Anschluss des i-ten Zeilenschaltelements 10d verbunden. Ein zweiter Anschluss der i-ten Zeilendiode 34d ist mit dem den Zeilenschaltelementen 10d gemeinsamen weiteren Referenzpotential 32d verbunden. Die i-te Zeilendiode 34d sperrt einen Strom **aus Richtung des den Zeilenschaltelementen 10d gemeinsamen weiteren Referenzpotentials 32d.** Die i-te Zeilendiode 34d lässt einen Strom **aus Richtung des den Zeilenschaltelementen 10d gemeinsamen weiteren Referenzpotentials 32d** zu.

Ein i,j-tes Heizmatrixelement 16d weist zumindest eine i,j-te weitere Kapazität 29d auf. Die i,j-te weitere Kapazität 29d ist ein Kondensator. Mittels der weiteren i,j-ten Kapazität 29d ist ein i,j-ter Induktor 18d zumindest mit einem den Heizmatrixelementen 16d gemeinsamen weiteren Referenzpotential 32d verbunden. Das den Heizmatrixelementen 16d gemeinsame weitere Referenzpotential 32d ist eine weitere Betriebsspannung. Ein erster Anschluss der i,j-ten weiteren Kapazität 29d ist mit einem i,j-ten weiteren Anschluss 42d des i,j-ten Induktors 18d verbunden. Ein zweiter Anschluss der i,j-ten **Kapazität 28d** ist mit dem den Heizmatrixelementen 16d gemeinsamen weiteren Referenzpotential 32d verbunden. Alternativ oder zusätzlich kann die i,j-te Kapazität 28d als ein Kondensatornetzwerk ausgebildet sein, welches mehrere Kondensatoren in Reihe und/oder parallel geschaltete Kondensatoren umfasst.

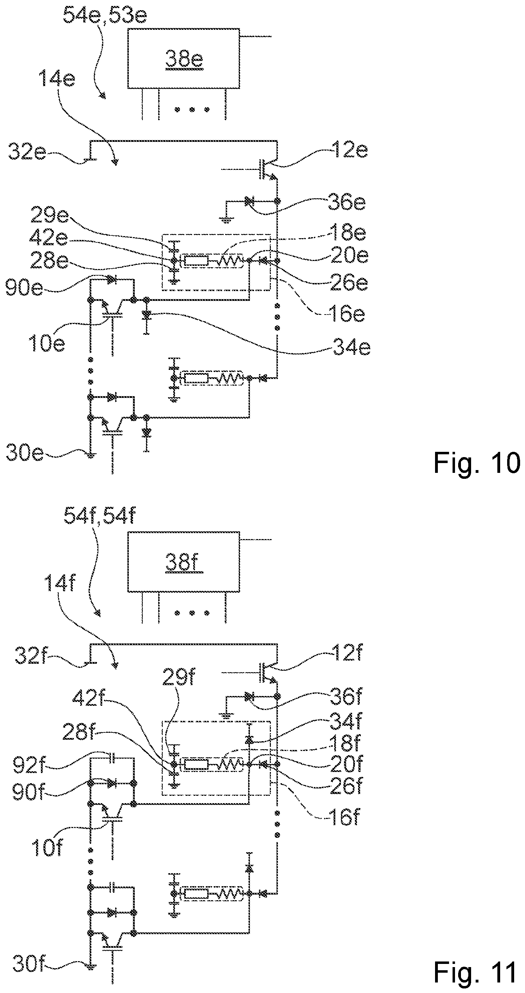

Fig.10 zeigt ein weiteres Ausführungsbeispiel der Erfindung. Das weitere Ausführungsbeispiel unterscheidet sich von dem vorherigen Ausführungsbeispiel zumindest im Wesentlichen hinsichtlich einer Anzahl N und einer Anzahl M. Die Gesamtanzahl N+M von Zeilenschaltelementen 10e und Spaltenschaltelementen 12e ist um eins größer ist als die Anzahl N×M von Heizmatrixelementen 16e. Im vorliegenden Fall ist die Anzahl N=2 und die Anzahl M=1. Die Heizmatrix 14e bildet einen schaltbildlichen Vektor aus. Bei einer Ausgestaltung, für die gilt, dass die Gesamtanzahl N+M um eins größer ist als die Anzahl N, kann auf i,1-te Dioden 24e verzichtet werden. Die Haushaltsgerätevorrichtung weist eine Anzahl von N Rücklaufdioden 90e auf. Die i-te Rücklaufdiode 90e ist mit dem i-ten Zeilenschaltelement 10e verbunden. Die i-te Rücklaufdiode 90e ist zu dem i-ten Zeilenschaltelement 10e parallel geschaltet. Ein erster Anschluss der i-ten Rücklaufdiode 90e ist mit einem ersten Anschluss des i-ten Zeilenschaltelements 10e verbunden. Ein zweiter Anschluss der i-ten Rücklaufdiode 90e ist mit einem zweiten Anschluss des i-ten Zeilenschaltelements 10e verbunden. Die i-te Rücklaufdiode 90e sperrt einen Stromfluss in Richtung des den Zeilenschaltelementen 10e gemeinsamen Referenzpotentials 30e. Die i-te Rücklaufdiode 90e lässt einen Stromfluss aus Richtung des den Zeilenschaltelementen 10e gemeinsamen Referenzpotentials 30e zu. Alternativ oder zusätzlich kann die Haushaltsgerätevorrichtung eine Anzahl von weiteren Rücklaufdioden 90e aufweisen. Eine j-te weitere Rücklaufdiode 90e könnte parallel mit einem j-ten Spaltenschaltelement 12e geschaltet sein.

Fig.11 zeigt ein weiteres Ausführungsbeispiel der Erfindung. Das weitere Ausführungsbeispiel unterscheidet sich von dem vorherigen Ausführungsbeispiel zumindest im Wesentlichen hinsichtlich einer Anzahl zusätzlicher elektrischer Bauteile. Die Haushaltsgerätevorrichtung weist eine Anzahl N von Zeilenkapazitäten 92f auf. Die i-te Zeilenkapazität 92f ist parallel zu einem i-ten Zeilenschaltelement 10f geschaltet. Ein erster Anschluss der i-ten Zeilenkapazität 92f ist mit einem ersten Anschluss des i-ten Zeilenschaltelements 10f verbunden. Ein zweiter Anschluss der i-ten Zeilenkapazität 92f ist mit einem zweiten Anschluss des i-ten Zeilenschaltelements 10f verbunden. Ferner unterscheidet sich das vorliegende Ausführungsbeispiel durch eine Schaltung von Zeilendioden 34f. Im vorliegenden Fall ist die i-te Zeilendiode 34f an einem i,j-ten Anschluss 20f eines i,j-ten Induktors 18f angeschlossen. Ein erster Anschluss der i-ten Zeilendiode 34f ist mit dem i,j-ten Anschluss 20f verbunden. Ein zweiter Anschluss der i-ten Zeilendiode 34f ist mit einem den Zeilenschaltelementen 10f gemeinsamen weiteren Referenzpotential 32f verbunden. Die i-te Zeilendiode 34f sperrt einen Strom **aus der Richtung des den Zeilenschaltelementen 10f gemeinsamen weiteren Referenzpotentials 32f.** Die i-te Zeilendiode 34f lässt einen Strom **aus Richtung des den Zeilenschaltelementen 10f gemeinsamen weiteren Referenzpotential 32f** durch.

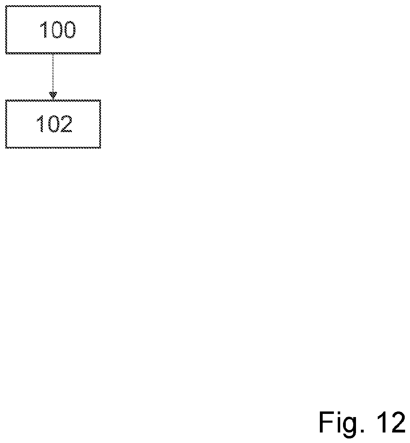

In Fig. 12 ist ein weiteres bevorzugtes Verfahren zu einer Steuerung der zuvor genannten Haushaltsgerätevorrichtung gezeigt. Durch das Verfahren kann eine Effizienz, insbesondere einer Kosteneffizienz und/oder einer Energieeffizienz der Haushaltsgerätevorrichtung verbessert werden. Vorteilhaft kann ein variabler Betrieb von Induktoren 18a-g verbessert werden. Weiter vorteilhaft kann eine schnellere Ansteuerung der Induktoren 18a-g erfolgen.

Das Verfahren ist hier anhand eines 1-ten Zeilenschaltelements 10, eines 2-ten Zeilenschaltelements 10, eines 1-ten Spaltenschaltelements 12, eines 1,1-ten Induktors 18 und eines 2,1-ten Induktors 18 beschrieben. Die folgende Beschreibung ist ferner von einem Fachmann auf weitere i-te, j-te und i,j-te elektrische Bauteile der Haushaltsgerätevorrichtung und insbesondere der weiteren Haushaltsgerätevorrichtungen, übertragbar.

In einem ersten Verfahrensschritt 100 steuert die Steuereinheit 38 die Zeilenschaltelemente 10 und das Spaltenschaltelement 12 zu einem Schaltvorgang an. Das1-te Zeilenschaltelement 10, das 2-te Zeilenschaltelement 10 und das1-te Spaltenschaltelement 12 bilden eine Schalteinheit 53 der Haushaltsgerätevorrichtung aus. In zumindest einem Betriebszustand liegt zumindest eine Betriebsspannung an der Schalteinheit 53 an. Die Steuereinheit 38 stellt durch das Schalten der Schalteinheit 53 zumindest eine Versorgungsspannung für den 1,1-ten Induktor 18 bereit. Die Steuereinheit 38 wandelt zumindest teilweise die Betriebsspannung durch eine Puls-Amplituden-Modulation in die Versorgungsspannung um. Ferner stellt die Steuereinheit 38 durch Schalten der Schalteinheit 53 zumindest eine weitere Versorgungsspannung für den 2,1-ten Induktor 18 bereit. Die Steuereinheit 38 wandelt zumindest teilweise die Betriebsspannung durch eine Puls-Amplituden-Modulation in die weitere Versorgungsspannung um.

In einem weiteren Verfahrensschritt 102 variiert die Steuereinheit 38 eine Frequenz der Versorgungsspannung innerhalb zumindest einer Periode der Betriebsspannung. Die Steuereinheit 38 variiert die Frequenz durch eine Puls-Pausen-Modulation der Betriebsspannung. Die Steuereinheit 38 variiert zusätzlich zumindest einen Tastgrad der Versorgungsspannung. Auf gleiche Weise variiert die Steuereinheit 38 eine weitere Frequenz und insbesondere einen Tastgrad der weiteren Versorgungsspannung zumindest innerhalb der Periode der Betriebsspannung. Die Steuereinheit 38 variiert die weitere Frequenz der weiteren Versorgungsspannung komplementär zu der Frequenz der Versorgungsspannung. Die Versorgungsspannung und die weitere Versorgungsspannung sind zumindest teilweise zueinander komplementär ausgestaltet. Die Steuereinheit 38 vermeidet beim Variieren der Frequenz eine Überlast an zumindest einem elektrischen Bauteil der Haushaltsgerätevorrichtung. Die Steuereinheit 38 vermindert beim Variieren der Frequenz eine elektromagnetische Abstrahlung. Die Steuereinheit 38 berücksichtigt dabei eine in einer Recheneinheit hinterlegte Leistungskennlinie.

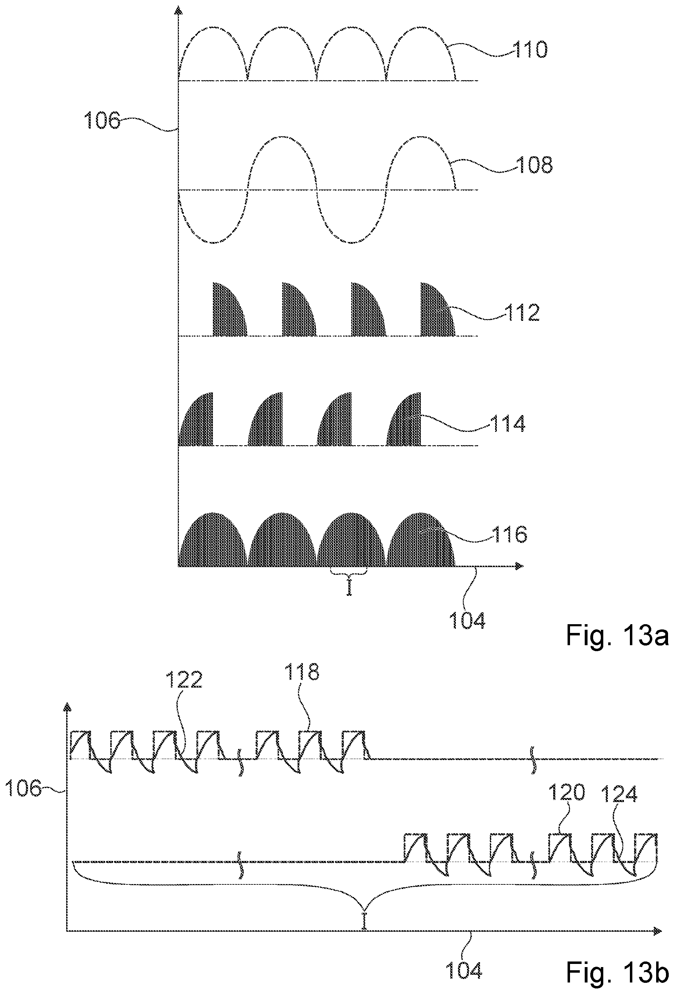

Fig. 13a zeigt ein Schaubild einer Steuerung des 1,1-ten Induktors 18 und des 2,1-ten Induktors 18. Auf einer Abszissenachse 104 ist eine Zeit aufgetragen. Eine Ordinatenachse 106 ist eine Werteachse. Das Schaubild umfasst eine Netzspannungskurve 108. Die Netzspannungskurve 108 zeigt einen zeitlichen Verlauf einer Netzspannung. Die Netzspannungskurve 108 erstreckt sich über zwei Perioden der Netzspannung. Die Netzspannung ist eine Wechselspannung. Die Netzspannung weist eine Netzfrequenz auf. Die Netzfrequenz beträgt 50 Hz. Das Schaubild stellt eine Betriebsspannungskurve 110 dar. Die Betriebsspannungskurve 110 zeigt einen zeitlichen Verlauf der Betriebsspannung. Die Betriebsspannungskurve 110 erstreckt sich über vier Perioden der Betriebsspannung. Die Netzspannung ist mittels eines Gleichrichters der Haushaltsgerätevorrichtung zumindest teilweise in die Betriebsspannung gewandelt. Die Betriebsspannung weist eine Frequenz von 100 Hz auf. Das Schaubild stellt eine Leistungskurve 112 dar. Die Leistungskurve 112 ist ein zeitlicher Verlauf einer Leistung, welche von dem 1,1-ten Induktor 18 an ein Gargeschirr abgegeben wird. Das Schaubild stellt eine weitere Leistungskurve 114 dar. Die weitere Leistungskurve 114 zeigt einen zeitlichen Verlauf einer Leistung, welche von dem 2,1-ten Induktor 18 an ein Gargeschirr abgegeben wird. Das Schaubild stellt eine Gesamtleistungskurve 116 dar. Die Gesamtleistungskurve 116 ist ein zeitlicher Verlauf einer Gesamtleistung, welche von dem 1,1-ten Induktor 18 und dem 2,1-ten Induktor 18 an ein Gargeschirr abgegeben wird. Die Gesamtleistungskurve 116 ergibt sich durch Addition der Leistungskurve 112 und der weiteren Leistungskurve 114.

In Fig. 13b ist ein weiteres Schaubild dargestellt. Das weitere Schaubild entspricht einem zeitlich vergrößerten Ausschnitt im Bereich I des Maximums der Betriebsspannungskurve 110. Das weitere Schaubild stellt eine Versorgungsspannungskurve 118 dar. Die Versorgungsspannungskurve 118 zeigt einen zeitlichen Verlauf der Versorgungsspannung, welche insbesondere an dem 1,1-ten Induktor 18 anliegt. Im Bereich I der maximalen Betriebsspannung wird die Frequenz der Versorgungsspannung von der Steuereinheit 38 variiert. Ferner ist ein Tastgrad der Versorgungsspannung von der Steuereinheit 38 variiert. Eine Pulsdauer der Versorgungsspannung bleibt konstant. Das weitere Schaubild stellt eine weitere Versorgungsspannungskurve 120 dar. Die weitere Versorgungsspannungskurve 120 zeigt einen zeitlichen Verlauf der weiteren Versorgungsspannung, welche insbesondere an dem 2,1-ten Induktor 18 anliegt. Im Bereich I der maximalen Betriebsspannung wird eine weitere Frequenz der weiteren Versorgungsspannung von der Steuereinheit 38 variiert. Ferner ist ein weiterer Tastgrad der weiteren Versorgungsspannung von der Steuereinheit 38 variiert. Eine weitere Pulsdauer der Versorgungsspannung bleibt konstant. Die Versorgungsspannung und die weiter Versorgungsspannung sind komplementär zueinander ausgestaltet. Das weitere Schaubild umfasst eine Heizstromkurve 122. Die Heizstromkurve 122 zeigt einen zeitlichen Verlauf eines Heizstroms, welcher durch den 1,1-ten Induktor 18, insbesondere abhängig von der Versorgungsspannung, fließt. Das weitere Schaubild umfasst eine weitere Heizstromkurve 124. Die weitere Heizstromkurve 124 zeigt einen zeitlichen Verlauf eines Heizstroms, welcher durch den 2,1-ten Induktor 18, insbesondere abhängig von der weiteren Versorgungsspannung, fließt. Eine an ein Gargeschirr abgegebene Leistung des 1,1-ten Induktors 18, wie insbesondere in der Leistungskurve 112 gezeigt, ergibt sich, insbesondere zumindest im Wesentlichen, durch Multiplikation des Versorgungsspannung mit dem Heizstrom. In gleicher Weise kann auch eine an ein Gargeschirr abgegebene Leistung des 2,1-ten Induktors 18 ermittelt werden.

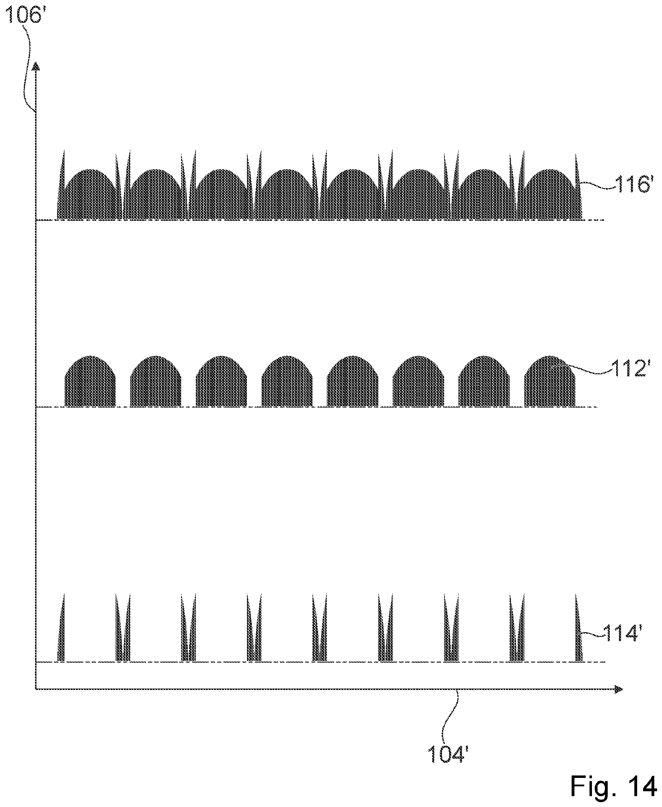

In Fig. 14 ist eine weitere Variation der Frequenz der Versorgungsspannung und der weiteren Frequenz der weiteren Versorgungsspannung anhand einer Leistungskurve 112', einer weiteren Leistungskurve 114' und einer Gesamtleistungskurve 116' gezeigt.

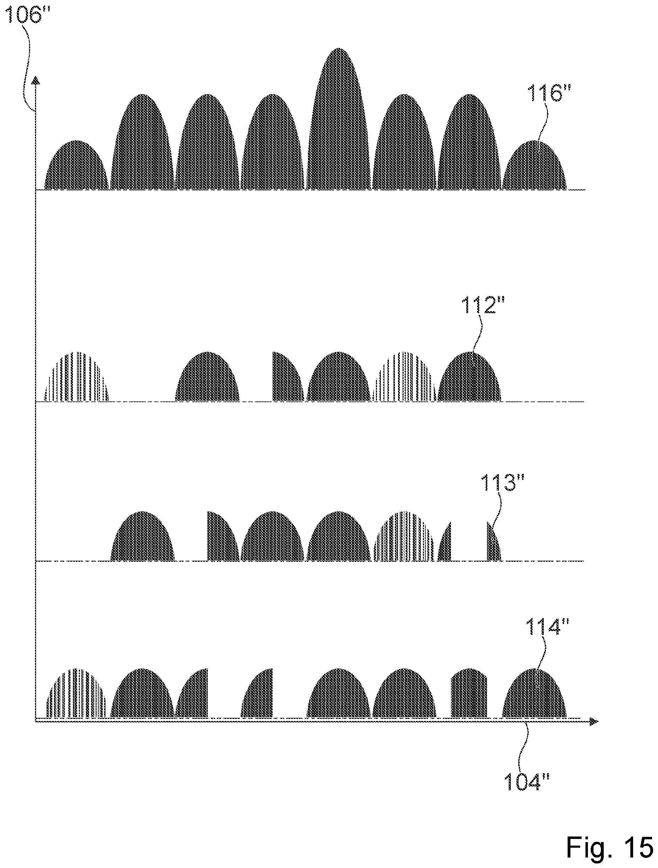

In Fig. 15 ist eine weitere Variation der Frequenz der Versorgungsspannung und der Frequenz der weiteren Versorgungsspannung gezeigt. Zudem ist eine Variation einer zusätzlichen Frequenz einer zusätzlichen Versorgungsspannung, welche einen zusätzlichen Induktor 18 betreibt, anhand einer Leistungskurve 112", einer weiteren Leistungskurve 114", einer zusätzliche Leistungskurve 113" und einer Gesamtleistungskurve 116" gezeigt.

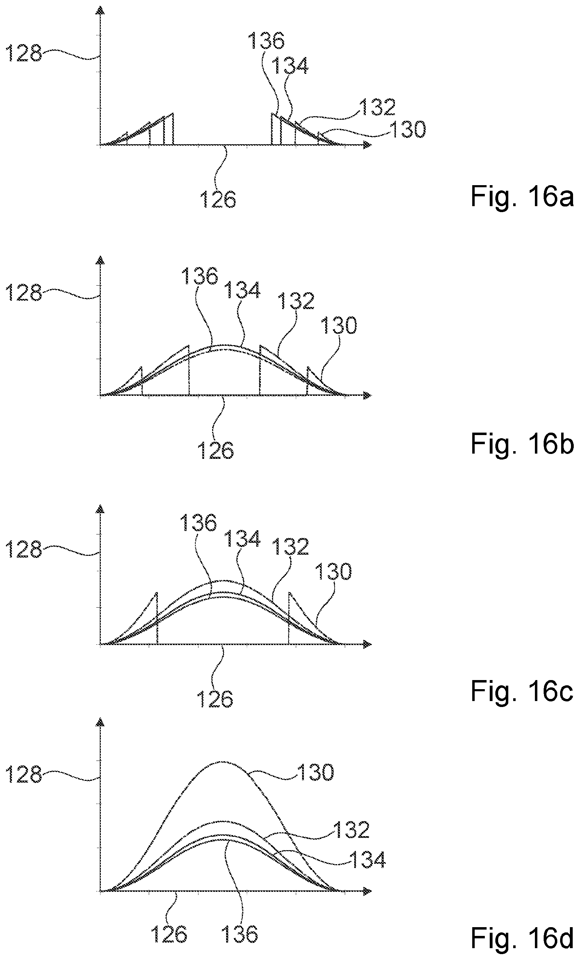

Fig. 16a-d zeigen Schaubilder mit typischen Leistungskennlinien 130, 132, 134, 136 einer Leistung, welche von einem Induktor 18 an ein Gargeschirr abgegeben wird. Das Gargeschirr besteht aus einem induktiven Material, und zwar insbesondere aus einer Legierung, insbesondere HAC. Auf einer Abszissenachse 126 ist eine Zeit aufgetragen. Eine Ordinatenachse 128 ist eine Werteachse. Eine erste Leistungskennlinie 130 zeigt einen zeitlichen Verlauf einer Leistung bei einem Überdeckungsgrad des Induktors 18 von 30 %. Eine zweite Leistungskennlinie 132 zeigt einen zeitlichen Verlauf einer Leistung bei einem Überdeckungsgrad des Induktors 18 von 50 % Eine dritte Leistungskennlinie 134 zeigt einen zeitlichen Verlauf einer Leistung bei einem Überdeckungsgrad des Induktors 18 von 75 % Eine vierte Leistungskennlinie 136 zeigt einen zeitlichen Verlauf einer Leistung bei einem Überdeckungsgrad des Induktors 18 von 100 %. Die Fig. 16a-d unterscheiden sich durch eine maximale Versorgungsspannung, welche an der Kapazität 28 anliegt. In der Fig. 16a liegt eine maximale Versorgungsspannung von zumindest 600 V an. In der Fig. 16b liegt eine maximale Versorgungsspannung von zumindest 900 V an. In der Fig. 16c liegt eine maximale Versorgungsspannung von zumindest 1200 V an. In der Fig. 16d ist eine maximale Versorgungsspannung unbeschränkt.

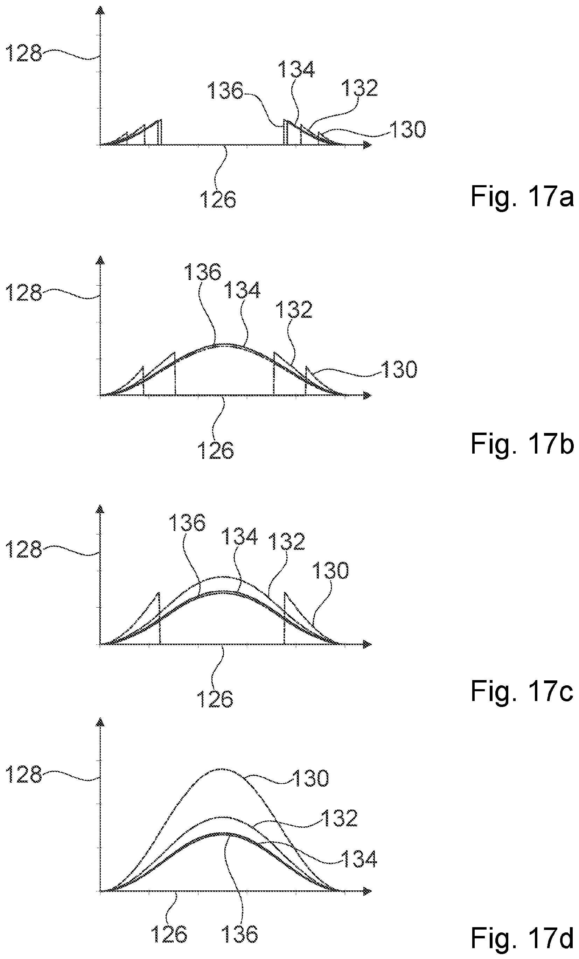

In den Fig. 17a-d sind zu den Schaubildern aus Fig. 16a-d äquivalente Schaubilder gezeigt für ein Gargeschirr, welches aus einem weiteren Material, insbesondere SIL, besteht.

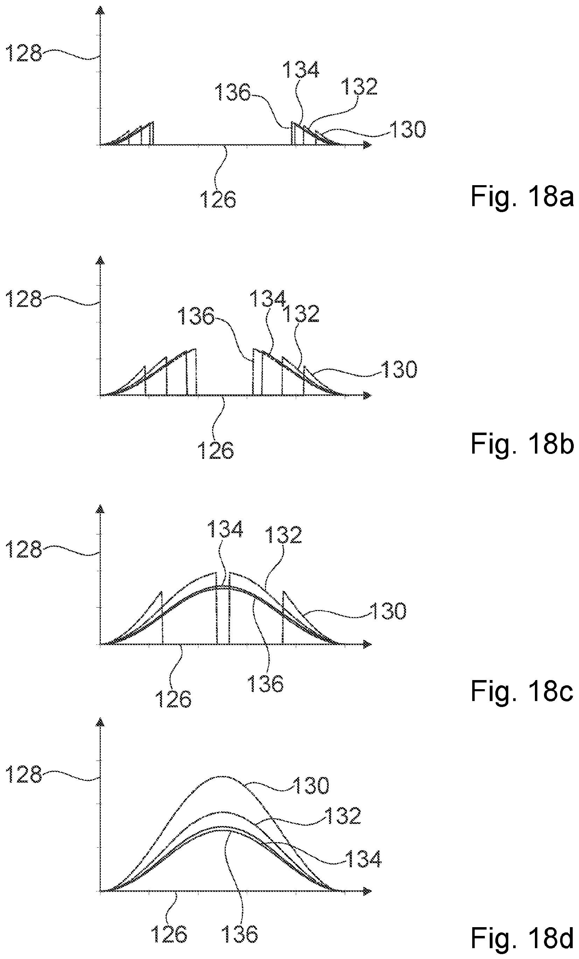

In den Fig. 18a-d sind zu den Schaubildern aus Fig. 17a-d äquivalente Schaubilder gezeigt für ein Gargeschirr, welches aus einem weiteren Material, insbesondere ZEN, besteht.

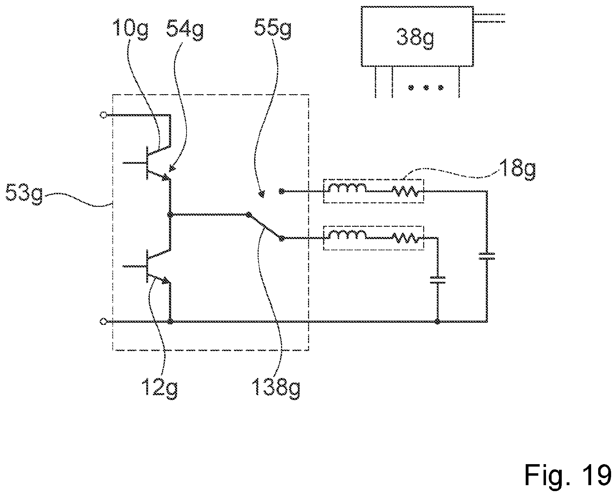

In Fig. 19 ist ein weiteres Ausführungsbeispiel der Haushaltsgerätevorrichtung dargestellt.

Im vorliegenden Fall weist die Haushaltsgerätevorrichtung eine Schalteinheit 53g mit zwei Schaltelementen 10g, 12g auf, welche in einer Halbbrücken-Topologie angeordnet sind. Die Schalteinheit 53g bildet zumindest teilweise zumindest eine Wechselrichtereinheit 54g aus. Die Wechselrichtereinheit 54g ist dazu vorgesehen, aus der Betriebsspannung zumindest eine Wechselrichterspannung zu erzeugen. Ferner weist die Schalteinheit 53g eine Variationsschalteinheit 55g auf. Die Variationsschalteinheit 55g umfasst ein zusätzliches Schaltelement 138g. Das zusätzliche Schaltelement 138g ist in einem ersten Schaltzustand mit einem Induktor 18g verbunden. Das zusätzliche Schaltelement 138g ist in einem zweiten Schaltzustand mit einem weiteren Induktor 18g der Haushaltsgerätevorrichtung verbunden. Im vorliegenden Fall ist die Steuereinheit 38g dazu vorgesehen, mittels der Variationsschalteinheit 55g die Wechselrichterspannung zumindest teilweise in eine Versorgungsspannung und eine weitere Versorgungsspannung zu wandeln. Ferner variiert die Steuereinheit 38g mittels der Variationsschalteinheit 55g die Frequenz der Versorgungsspannung und der weiteren Versorgungsspannung.

### Bezugszeichen

- 10: Zeilenschaltelement
- 12: Spaltenschaltelement
- 14: Heizmatrix
- 16: Heizmatrixelement
- 18: Induktor
- 20: Anschluss
- 22: Induktormatrix
- 24: Diode
- 26: Weitere Diode
- 28: Kapazität
- 29: Kapazität
- 30: Referenzpotential (Erde)
- 32: Weiteres Referenzpotential
- 34: Zeilendiode
- 36: Spaltendiode
- 38: Steuereinheit
- 40: Gargeschirrerkennungsmodus
- 42: Weiterer Anschluss
- 44: Betriebsspannung
- 46: Kennlinie
- 47: Kennlinie
- 48: Haushaltsgerät
- 50: Kochfeldfeldplatte
- 52: Heizzonenposition
- 53: Schalteinheit
- 54: Wechselrichtereinheit
- 55: Variationsschalteinheit
- 56: Betriebsschritt
- 58: Ladeschritt
- 60: Entladeschritt
- 62: Bestimmungsschritt
- 64: Abszissenachse
- 66: Ordinatenachse
- 68: Erste Spannungskurve
- 70: Zweite Spannungskurve
- 72: Dritte Spannungskurve
- 74: Vierte Spannungskurve
- 76: Fünfte Spannungskurve
- 80: Erste Stromkurve
- 82: Zweite Stromkurve
- 84: Dritte Stromkurve
- 86: Vierte Stromkurve
- 88: Wechselrichterelement
- 90: Rücklaufdiode
- 92: Zeilenkapazität
- 100: Verfahrensschritt
- 102: Verfahrensschritt
- 104: Abszissenachse
- 106: Ordinatenachse
- 108: Netzspannungskurve
- 110: Betriebsspannungskurve
- 112: Leistungskurve
- 113: Zusätzliche Leistungskurve
- 114: Weitere Leistungskurve
- 116: Gesamtleistungskurve
- 118: Versorgungsspannungskurve
- 120: Weitere Versorgungsspannungskurve
- 122: Heizstromkurve
- 124: Weitere Heizstromkurve
- 126: Abszissenachse
- 128: Ordinatenachse
- 130: Erste Leistungskennlinie
- 132: Zweite Leistungskennlinie
- 134: Dritte Leistungskennlinie
- 136: Vierte Leistungskennlinie
- 138: Zusätzliches Schaltelement

## Patentansprüche

1. Haushaltsgerätevorrichtung, insbesondere Gargerätevorrichtung, mit zumindest einem Induktor (18a-g), mit zumindest einer Schalteinheit (53a-g), an welcher in zumindest einem Betriebszustand zumindest eine Betriebsspannung anliegt, und mit einer Steuereinheit (38a-g), welche dazu vorgesehen ist, durch Schalten der Schalteinheit (53a-g) zumindest eine Versorgungsspannung für den Induktor (18a-g) bereitzustellen, wobei die Steuereinheit (38a-g) dazu vorgesehen ist, in zumindest einem Betriebszustand zumindest eine Frequenz einer Puls-Modulation der Versorgungsspannung innerhalb zumindest einer Periode der Betriebsspannung zu variieren,
**dadurch gekennzeichnet, dass**
die Steuereinheit (38a-g) dazu vorgesehen ist, in dem Betriebszustand zusätzlich zumindest einen Tastgrad der Puls-Modulation der Versorgungsspannung innerhalb der zumindest einen Periode der Betriebsspannung zu variieren.

2. Haushaltsgerätevorrichtung nach Anspruch 1,
**gekennzeichnet durch**
zumindest einen weiteren Induktor (18a-g), wobei die Steuereinheit (38a-g) dazu vorgesehen ist, durch Schalten der Schalteinheit (53a-g) zumindest eine weitere Versorgungsspannung für den weiteren Induktor (18a-g) bereitzustellen und in zumindest einem Betriebszustand zumindest eine weitere Frequenz der weiteren Versorgungsspannung innerhalb zumindest einer Periode der Betriebsspannung zu variieren.

3. Haushaltsgerätevorrichtung nach Anspruch 2,
**dadurch gekennzeichnet, dass**
die Versorgungsspannung und die weitere Versorgungsspannung zumindest teilweise zueinander komplementär ausgestaltet sind.

4. Haushaltsgerätevorrichtung nach einem der vorhergehenden Ansprüche,
**dadurch gekennzeichnet, dass**
die Schalteinheit (53a-g) zumindest eine Wechselrichtereinheit (54a-g) aufweist, die dazu vorgesehen ist, aus der Betriebsspannung zumindest eine Wechselrichterspannung zu erzeugen, und zumindest eine Variationsschalteinheit (55g) aufweist, die dazu vorgesehen ist, aus der Wechselrichterspannung zumindest die Versorgungsspannung zu erzeugen.

5. Haushaltsgerätevorrichtung nach Anspruch 4,
**dadurch gekennzeichnet, dass**
die Steuereinheit (38a-g) dazu vorgesehen ist, die Versorgungsspannung in dem Betriebszustand mittels der Variationsschalteinheit (55g) zu variieren.

6. Haushaltsgerätevorrichtung nach einem der vorhergehenden Ansprüche,
**gekennzeichnet durch**
zumindest eine Heizmatrix (14a-f), welche eine Anzahl N×M von Heizmatrixelementen (16a-f) aufweist, wobei die Schalteinheit (53a-f) zumindest eine Anzahl N von Zeilenschaltelementen (10a-f) und zumindest eine Anzahl M von Spaltenschaltelementen (12a-f) aufweist, wobei für beliebige i von 1 bis N und beliebige j von 1 bis M mit einer Gesamtanzahl N+M von Zeilenschaltelementen (10a-f) und Spaltenschaltelementen (12a-f) größer als 2 gilt, dass das i,j-te Heizmatrixelement (16a-f) zumindest einen i,j-ten Induktor (18a-f) umfasst und sowohl mit dem i-ten Zeilenschaltelement (10a-f) als auch mit dem j-ten Spaltenschaltelement (12a-f) verbunden ist.

7. Haushaltsgerät (48a), insbesondere Gargerät, mit einer Haushaltsgerätevorrichtung nach einem der vorhergehenden Ansprüche.

8. Verfahren zum Betrieb einer Haushaltsgerätevorrichtung, insbesondere einer Gargerätevorrichtung, insbesondere nach einem der Ansprüche 1 bis 6, mit zumindest einem Induktor (18a-g) und mit zumindest einer Schalteinheit (53a-g), an welcher in zumindest einem Betriebszustand zumindest eine Betriebsspannung anliegt, wobei durch Schalten der Schalteinheit (53a-g) zumindest eine Versorgungsspannung für den Induktor (18a-g) bereitgestellt wird, wobei in zumindest einem Betriebszustand zumindest eine Frequenz einer Puls-Modulation der Versorgungsspannung innerhalb zumindest einer Periode der Betriebsspannung variiert wird,
**dadurch gekennzeichnet, dass**
in dem Betriebszustand zusätzlich zumindest ein Tastgrad der Puls-Modulation der Versorgungsspannung innerhalb der zumindest einen Periode der Betriebsspannung variiert wird.

## Claims

1. Household appliance device, in particular a cooking appliance device, with at least one inductor (18a-g), with at least one switching unit (53a-g), at which at least one operating voltage is present in at least one operating state, and with a control unit (38a-g), which is provided to supply at least one supply voltage for the inductor (18a-g) by switching the switching unit (53a-g), wherein the control unit (38a-g) is provided to vary at least one frequency of a pulse modulation of the supply voltage within at least one period of the operating voltage in at least one operating state,
**characterised in that**
the control unit (38a-g) is provided also to vary at least one duty factor of the pulse modulation of the supply voltage within the at least one period of the operating voltage in the operating state.

2. Household appliance device according to claim 1,
**characterised by**
at least one further inductor (18a-g), wherein the control unit (38a-g) is provided to supply at least one further supply voltage for the further inductor (18a-g) by switching the switching unit (53a-g) and to vary at least one further frequency of the further supply voltage within at least one period of the operating voltage in at least one operating state.

3. Household appliance device according to claim 2,
**characterised in that**
the supply voltage and the further supply voltage are configured to complement one another at least partially.

4. Household appliance device according to one of the preceding claims,
**characterised in that**
the switching unit (53a-g) has at least one inverter unit (54a-g), which is provided to generate at least one inverter voltage from the operating voltage and has at least one variation switching unit (55g), which is provided to generate at least the supply voltage from the inverter voltage.

5. Household appliance device according to claim 4,
**characterised in that**
the control unit (38a-g) is provided to vary the supply voltage in the operating state by means of the variation switching unit (55g).

6. Household appliance device according to one of the preceding claims,
**characterised by**
at least one heating matrix (14a-f), which has a number NxM of heating matrix elements (16a-f), wherein the switching unit (53a-f) has at least a number N of row switching elements (10a-f) and at least a number M of column switching elements (12a-f), wherein, for any i from 1 to N and any j from 1 to M with a total number N+M of row switching elements (10a-f) and column switching elements (12a-f) greater than 2, the heating matrix element (16a-f) at position i,j comprises at least one inductor (18a-f) at position i,j and is connected to both the i-th row switching element (10a-f) and the j-th column switching element (12a-f).

7. Household appliance (48a), in particular a cooking appliance, with a household appliance device according to one of the preceding claims.

8. Method for operating a household appliance device, in particular a cooking appliance device, in particular according to one of claims 1 to 6, with at least one inductor (18a-g) and with at least one switching unit (53a-g), at which at least one operating voltage is present in at least one operating state, wherein at least one supply voltage for the inductor (18a-g) is provided by switching the switching unit (53a-g), wherein at least one frequency of a pulse modulation of the supply voltage is varied within at least one period of the operating voltage in at least one operating state,
**characterised in that**
at least one duty factor of the pulse modulation of the supply voltage within the at least one period of the operating voltage is additionally varied in the operating state.

## Revendications

1. Dispositif pour appareil électroménager, en particulier dispositif pour appareil de cuisson, comprenant au moins un inducteur (18a-g), au moins une unité de commutation (53a-g), au niveau de laquelle au moins une tension de service est appliquée dans au moins un état de fonctionnement, et une unité de commande (38a-g), qui est conçue pour fournir au moins une tension d'alimentation pour l'inducteur (18a-g) par commutation de l'unité de commutation (53a-g),
dans lequel l'unité de commande (38a-g) est conçue pour faire varier, dans au moins un état de fonctionnement, au moins une fréquence d'une modulation d'impulsion de la tension d'alimentation en l'espace d'au moins une période de la tension de service, **caractérisé en ce que** l'unité de commande (38a-g) est conçue pour faire varier dans l'état de fonctionnement en outre au moins un rapport cyclique de la modulation d'impulsion de la tension d'alimentation en l'espace de l'au moins une période de la tension de service.

2. Dispositif pour appareil électroménager selon la revendication 1,
**caractérisé par** au moins un inducteur supplémentaire (18a-g), dans lequel l'unité de commande (38a-g) est conçue pour fournir au moins une tension d'alimentation supplémentaire pour l'inducteur supplémentaire (18a-g) par commutation de l'unité de commutation (53a-g) et pour faire varier, dans au moins un état de fonctionnement, au moins une fréquence supplémentaire de la tension d'alimentation supplémentaire en l'espace d'au moins une période de la tension de service.

3. Dispositif pour appareil électroménager selon la revendication 2,
**caractérisé en ce que** la tension d'alimentation et la tension d'alimentation supplémentaire sont configurées au moins en partie de façon complémentaire l'une à l'autre.

4. Dispositif pour appareil électroménager selon l'une quelconque des revendications précédentes,
**caractérisé en ce que** l'unité de commutation (53a-g) comprend au moins une unité d'onduleur (54a-g), qui est conçue pour générer à partir de la tension de service au moins une tension d'onduleur, et comprend au moins une unité de commutation de variation (55g), qui est conçue pour générer à partir de la tension d'onduleur au moins la tension d'alimentation.

5. Dispositif pour appareil électroménager selon la revendication 4,
**caractérisé en ce que** l'unité de commande (38a-g) est conçue pour faire varier la tension d'alimentation dans l'état de fonctionnement au moyen de l'unité de commutation de variation (55g).

6. Dispositif pour appareil électroménager selon l'une quelconque des revendications précédentes,
**caractérisé par** une matrice chauffante (14a-f), qui comprend un nombre N x M d'éléments de matrice chauffante (16a-f),
dans lequel l'unité de commutation (53a-f) comprend au moins un nombre N d'éléments de commutation de ligne (10a-f) et au moins une nombre M d'éléments de commutation de colonne (12a-f),
dans lequel, pour n'importe quel i de 1 à N et pour n'importe quel j de 1 à M, avec un nombre total N + M d'éléments de commutation de ligne (10a-f) et d'éléments de commutation de colonne (12a-f) supérieur à 2, il s'applique que le i,j-ème élément de matrice chauffante (16a-f) comprend au moins un i,j-ème inducteur (18a-f), et est relié aussi bien au i-ème élément de commutation de ligne (10a-f) qu'au j-ème élément de commutation de colonne (12a-f).

7. Appareil électroménager (48a), en particulier appareil de cuisson, comprenant un dispositif pour appareil électroménager selon l'une des revendications précédentes.

8. Procédé de fonctionnement d'un dispositif pour appareil électroménager, en particulier d'un dispositif pour appareil de cuisson, en particulier selon l'une des revendications 1 à 6, comprenant au moins un inducteur (18a-g) et au moins une unité de commutation (53a-g), au niveau de laquelle au moins une tension de service est appliquée dans au moins un état de fonctionnement,
dans lequel au moins une tension d'alimentation pour l'inducteur (18a-g) est fournie par commutation de l'unité de commutation (53a-g),
dans lequel, dans au moins un état de fonctionnement, au moins une fréquence d'une modulation d'impulsion de la tension d'alimentation est modifiée en l'espace d'au moins une période de la tension de service,
**caractérisé en ce qu'**en outre, dans l'état de fonctionnement, au moins un rapport cyclique de la modulation d'impulsion de la tension d'alimentation est modifié en l'espace de l'au moins une période de la tension de service.
